(19) Europäisches Patentamt
European Patent Office
Office européen des brevets

(11) EP 1 290 047 B1

(12) EUROPÄISCHE PATENTSCHRIFT

(45) Veröffentlichungstag und Bekanntmachung des Hinweises auf die Patenterteilung:
**17.08.2005 Patentblatt 2005/33**

(21) Anmeldenummer: **01947291.9**

(22) Anmeldetag: **18.05.2001**

(51) Int Cl.[7]: **C08F 120/00**, C08F 220/00

(86) Internationale Anmeldenummer:
**PCT/EP2001/005709**

(87) Internationale Veröffentlichungsnummer:
**WO 2001/092353 (06.12.2001 Gazette 2001/49)**

(54) **MISCHPOLYMERE ZUR OPTISCHEN DATENSPEICHERUNG**

COPOLYMERS FOR OPTICAL DATA STORAGE

COPOLYMERES POUR LE STOCKAGE OPTIQUE DE DONNEES

(84) Benannte Vertragsstaaten:
**AT BE CH CY DE DK ES FI FR GB GR IE IT LI LU MC NL PT SE TR**

(30) Priorität: **31.05.2000 DE 10027152**

(43) Veröffentlichungstag der Anmeldung:
**12.03.2003 Patentblatt 2003/11**

(73) Patentinhaber: **Bayer MaterialScience AG**
**51368 Leverkusen (DE)**

(72) Erfinder:
- **BERNETH, Horst**
  **51373 Leverkusen (DE)**
- **BIERINGER, Thomas**
  **51519 Odenthal (DE)**
- **HAGEN, Rainer**
  **51373 Leverkusen (DE)**
- **KOSTROMINE, Serguei**
  **53913 Swisttal (RU)**

(56) Entgegenhaltungen:
**DE-A- 4 434 966** **DE-A- 19 720 288**

- **SYLLA M ET AL: "Synthesis, characterization and nonlinear optical properties study of polymers based on coloured monomers" POLYMER, ELSEVIER SCIENCE PUBLISHERS B.V, GB, Bd. 41, Nr. 10, Mai 2000 (2000-05), Seiten 3507-3511, XP004188965 ISSN: 0032-3861**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft Mischpolymere und die Verwendung dieser zur optischen Datenspeicherung.

Photoadressierbare Polymere sind bekannt (Polymers as Electrooptical and Fotooptical Active Media, V. P. Shibaev (Hrsg.), Springer Verlag, New York 1995). Insbesondere eignen sich für diesen Zweck Seitengruppenpolymere, von denen die Gruppe der Copolymeren sich durch eine sehr breite Variationsmöglichkeit der Eigenschaften auszeichnet. Ihre besondere Eigenart ist, dass ihre optischen Eigenschaften wie Absorption, Emission, Reflexion, Doppelbrechung, Streuung lichtinduziert reversibel verändert werden können. Derartige Polymere haben eine spezielle kammartige Struktur: An einem linearen Rückgrat sitzen - über als Abstandshalter wirkende Molekülteile verbunden - Seitengruppen, die elektromagnetische Strahlung absorbieren können. Beispiele dieser Art sind Farbstoffmoleküle, insbesondere die Azobenzolgruppen enthaltenden Seitengruppenpolymeren gemäß US-A 5 173 381. Diese Substanzen kennzeichnet die Fähigkeit, beim Bestrahlen mit polarisiertem Licht eine gerichtete Doppelbrechung auszubilden. Die eingeschriebenen Doppelbrechungsmuster lassen sich im polarisierten Licht sichtbar machen.

Es ist weiterhin bekannt, dass man in Schichten aus diesen Polymeren an einer beliebigen Stelle mit polarisiertem Licht eine örtlich begrenzte Doppelbrechung einschreiben kann, deren Vorzugsachse sich beim Drehen der Polarisationsrichtung mitbewegt (K. Anderle, R. Birenheide, M. Eich, J.H. Wendorff, Makromol. Chem., Rapid Commun. 10, 477 - 483 (1989), J. Stumpe et al., 20. Freiburger Arbeitstagung Flüssigkristalle 1991).

Für die Herstellung der photoadressierbaren Substrate sind prinzipiell alle Polymere geeignet, in die sich eine gerichtete Doppelbrechung einschreiben lässt (Polymers as Electroopticcal and Fotooptical Active Media, V. P. Shibaev (Hrsg.), Springer Verlag, New York 1995; Natansohn et al., Chem. Mater. 1993, 403-411). Insbesondere sind dies Seitengruppenpolymere, von denen die Copolymeren bevorzugt sind. Bevorzugte derartige Copolymere werden beispielsweise in den DE-A 43 10 368 und DE-A 44 34 966 beschrieben. Sie enthalten vorzugsweise eine als Rückgrat wirkende Poly(meth)acrylat-Hauptkette mit wiederkehrenden Einheiten

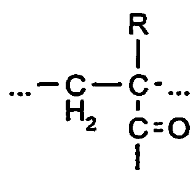

worin R für Wasserstoff oder Methyl steht, die Punkte die Anknüpfung der weiteren Einheiten der Hauptkette andeuten und die Seitenkette an die Carbonylgruppe angeknüpft ist.

In der DE-A-19 620 588 sind Polymere bekannt, die von der Hauptkette abzweigenden Seitenketten der Formeln -S-T-Q-P mit P = A, M:

$$-S^1-T^1-Q^1-A \qquad (I)$$

und

$$-S^2-T^2-Q^2-M \qquad (II)$$

enthalten, worin

$S^1$, $S^2$ unabhängig voneinander die Atome O, S oder den Rest $NR^1$,

$R^1$ Wasserstoffoder $C_1$-$C_4$-Alkyl,

$T^1$ , $T^2$ unabhängig voneinander den Rest $(CH_2)_n$, der gegebenenfalls durch -O-, $-NR^1-$ oder $-OSiR^1{}_2O-$ unterbrochen und/oder durch Methyl oder Ethyl substituiert sein kann,

n die Zahlen 2, 3 oder 4,

$Q^1$, $Q^2$ einen zweibindigen Rest,

A eine Einheit, die elektromagnetische Strahlung absorbieren kann, und

M eine polarisierbare aromatische Gruppe mit wenigstens 12 π-Elektronen bedeuten.

Die Funktion von M ist die kooperative Umorientierung zusammen mit den eigentlichen absorbierenden Einheiten. Hieraus resultiert eine Verstärkung der Umorientierung und Stabilisierung der umorientierten Moleküle.

Besonders bevorzugt sind Polymere, in denen

$Q^1$, $Q^2$ unabhängig voneinander $Z^1$, $Z^2$ oder die Gruppe $-Z^1-X-Z^2-$ bedeutet, worin

$Z^1$, $Z^2$ unabhängig voneinander die Gruppen -S-, $-SO_2-$, -O-, -COO-, -OCO-, $-CONR^1-$, $-NR^1CO-$, $-NR^1-$, -N=N-, -CH=CH-, -N=CH-, -CH=N- oder die Gruppe $-(CH_2)_m-$ mit m = 1 oder 2 und

X einen 5- oder 6-gliedrigen cycloaliphatischen, aromatischen oder heterocyclischen Ring, für den Fall $Z^1$ = -COO- oder $-CONR^1-$ eine direkte Bindung oder die Gruppe $-(CH=CH)_m-$,
wobei m die oben angegebene Bedeutung hat,

A den Rest eines Mono-Azofarbstoffs, der im Wellenlängenbereich zwischen 650 und 340 nm absorbiert, und

M den Rest eines polarisierten und weiter polarisierbaren aromatischen, linear aufgebauten Systems mit wenigstens 12 π-Elektronen bedeuten.

Bevorzugte Reste A entsprechen der Formel

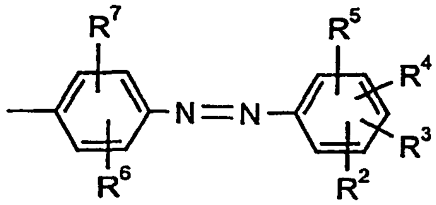

worin

$R^2$ bis $R^7$ unabhängig voneinander Wasserstoff, Hydroxyl, Halogen, Nitro, Cyan, $C_1$-$C_4$-Alkyl, $C_1$-$C_4$-Alkoxy, $CF_3$, $CCl_3$, $CBr_3$, $SO_2CF_3$, $C_1$-$C_6$-Alkylsulfonyl, Phenylsulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl oder $COOR^1$ bedeuten.

Bevorzugte Reste M entsprechen der Formel

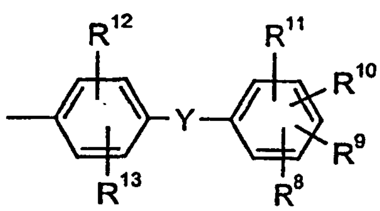

worin

$R^8$ bis $R^{13}$ unabhängig voneinander Wasserstoff, Hydroxyl, Halogen, Nitro, Cyan, $C_1$-$C_4$-Alkyl, $C_1$-$C_4$-Alkoxy, $CF_3$, $CCl_3$, $CBr_3$, $SO_2CF_3$, $C_1$-$C_6$-Alkylsulfonyl, Phenylsulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl oder $COOR^1$ und

Y -COO-, -OCO-, -CONH-, -NHCO-, -O-, -NH-, $-N(CH_3)-$ oder eine Einfachbindung

bedeuten.

Bevorzugt sind amorphe Polymere, also solche, die keine makroskopisch wahrnehmbaren flüssigkristallinen Phasen ausbilden. "Amorph" bedeutet einen optisch isotropen Zustand. Solche Polymeren streuen weder das sichtbare Licht noch besitzen sie ohne Einwirkung von externen Kräften im isotropen Ausgangszustand eine Doppelbrechung.

Ebenfalls ist als ein Verfahren zur Herstellung die radikalische Polymerisation genannt.

Ebenfalls bekannt sind Materialien zur holographischen Datenspeicherung.

Die Holographie ist ein Verfahren, bei dem man durch die Interferenz zweier kohärenter Lichtstrahlen (Signalwelle und Referenzwelle) Objekte in geeigneten Speichermaterialien abbilden kann und diese Abbilder wieder mit Licht (Lesestrahl) auslesen kann (D. Gabor, Nature **151**, 454 (1948), N. H. Farath, Advances in Holography, Vol. 3, Marcel Decker (1977), H. M. Smith, Holographic Recording Materials, Springer (1977)). Durch Änderung des Winkels zwischen Signal- und Referenzwelle einerseits und dem holographischen Speichermaterial andererseits lassen sich zahlreiche Hologramme in das Material einschreiben und schließlich auch wieder einzeln auslesen. Als kohärente Lichtquelle dient in der Regel das Licht eines Lasers. Als Speichermaterial sind verschiedenste Materialien beschrieben, z. B. anorganische Kristalle wie $LiNbO_3$ (z. B.), organische Polymere (z. B. M. Eich, J. H. Wendorff, Makromol. Chem., Rapid Commun. **8**, 467 (1987), J. H. Wendorff, M. Eich, Mol. Cryst. Liq. Cryst. **169**, 133 (1989)) oder Fotopolymere (Uh-Sock Rhee et al., Applied Optics, 34 (5), 846 (1995)).

Diese Materialien erfüllen jedoch noch nicht alle Anforderungen eines holographischen Aufzeichnungsmediums. Insbesondere besitzen sie keine ausreichenden Stabilitäten des eingeschriebenen Hologramms. Eine Mehrfachbeschreibung ist in der Regel nur bedingt möglich, da beim Einschreiben eines neuen Hologramms das bereits eingeschriebene Hologramm überschrieben und somit gelöscht wird. Dies gilt insbesondere für anorganische Kristalle, die einer aufwendigen Temperaturbehandlung unterzogen werden, um diese Stabilitätsprobleme zu kompensieren. Photopolymere zeigen hingegen das Problem des Schrumpfes, was die holographischen Abbildungseigenschaften negativ beeinflusst.

Materialien mit hoher Stabilität der eingeschriebenen Hologramme sind ebenfalls bekannt, z.B. aus EP-A 0 704 513.

Die hohe optische Dichte dieser Materialien erlaubt jedoch nicht die Herstellung von holographischen Volumenspeichern, wie sie zur Speicherung zahlreicher Hologramme in einem Speichermaterial erforderlich sind.

Es bestand demnach ein Bedarf nach einem Material, das zur Herstellung ausreichend dicker holographischer Volumenspeicher geeignet ist. Die Dicke der Materialien sollte im Bereich von Millimeter liegen. Bei den Materialien des Standes der Technik kommt es dabei fast immer zu Durchdringungsproblemen der Laserstrahlen aufgrund der hohen optischen Dichte.

Aufgabe war eine Vermeidung dieses Problems bei gleichzeitiger Gewährleistung der hohen Speichereffizienz. Es ist zu beobachten, dass bei zunehmender Verdünnung der Farbstoffe in Copolymeren (Abnahme der optischen Dichte) auch eine Abnahme der holographischen Beugungseffizienz zu beobachten ist.

Überraschenderweise wurde nun gefunden, dass Mischungen von Polymeren mit speziellen chemischen Architekturen möglich sind und diesen Nachteil nicht aufweisen.

Gegenstand der vorliegenden Anmeldung ist also ein Misch-Polymer, dadurch gekennzeichnet, dass es aus mindestens einem Polymer (A) mit mindestens 10 Wiederholeinheiten der allgemeinen Formel (CI)

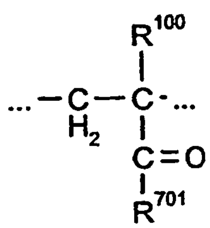

(CI),

worin

$R^{100}$ für Wasserstoff oder Methyl und

$R^{701}$ für -O-$R^{801}$, wobei

$R^{801}$ für Wasserstoff oder $C_1$-$C_8$ linear oder verzweigt Alkyl ohne fotoisomerisierbare Gruppe, bevorzugt Methyl, Ethyl, Propyl, n-Butyl, besonders bevorzugt Methyl steht, und

mindestens einem Polymer (B) mit mindestens 3 Wiederholeinheiten der allgemeinen Formel (CII)

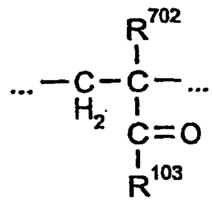

(CII)

besteht, wobei

$R^{702}$ für Wasserstoff oder Methyl und

$R^{103}$ für [-S-T-Q-P] steht und wobei P für A und/oder M steht,

wobei aber stets ein Polymer (B) enthalten ist, bei dem P für A steht.

Für die von der Hauptkette abzweigende Seitenkette der Formel S-T-Q-P mit P = A (Farbstoffgruppe), M (Mesogen) gelten die folgenden Definitionen:

$$S\text{-}T\text{-}Q\text{-}P = S^1 - T^1 - Q^1 - A$$

$$S\text{-}T\text{-}Q\text{-}P = S^2 - T^2 - Q^2 - M$$

wobei

$S^1$, $S^2$ unabhängig voneinander die Atome O, S oder den Rest $NR^1$ ,

$R^1$ Wasserstoff oder $C_1$-$C_4$-Alkyl,

$T^1$ , $T^2$ unabhängig voneinander den Rest $(CH_2)_n$, der gegebenenfalls durch -O-, $-NR^1-$ oder $-OSiR^1{}_2O-$ unterbrochen und/oder durch Methyl oder Ethyl substituiert sein kann,

n die Zahlen 2, 3 oder 4,

$Q^1$, $Q^2$ einen zweibindigen Rest,

A eine Einheit, die elektromagnetische Strahlung absorbieren kann, und

M eine polarisierbare aromatische Gruppe mit wenigstens 12 $\pi$-Elektronen bedeuten.

Die Funktion von M ist die kooperative Umorientierung zusammen mit den eigentlichen absorbierenden Einheiten. Hieraus resultiert eine Verstärkung der Umorientierung und Stabilisierung der umorientierten Moleküle.

Besonders bevorzugt sind Polymere, in denen

$Q^1$, $Q^2$ unabhängig voneinander $Z^1$, $Z^2$ oder die Gruppe $-Z^1$-X-$Z^2-$ bedeutet, worin

$Z^1$, $Z^2$ unabhängig voneinander die Gruppen -S-, $-SO_2-$, -O-, -COO-, -OCO-, $-CONR^1-$, $-NR^1CO-$, $-NR^1-$, -N=N-, -CH=CH-, -N=CH-, -CH=N- oder die Gruppe $-(CH_2)_m-$ mit m = 1 oder 2 und

X einen 5- oder 6-gliedrigen cycloaliphatischen, aromatischen oder heterocyclischen Ring, für den Fall $Z^1$ = -COO- oder $-CONR^1-$ eine direkte Bindung oder die Gruppe $-(CH=CH)_m-$,
wobei m die oben angegebene Bedeutung hat,

A den Rest eines Mono-Azofarbstoffs, der im Wellenlängenbereich zwischen 650 und 340 nm absorbiert, und

M den Rest eines polarisierten und weiter polarisierbaren aromatischen, linear aufgebauten Systems mit wenigstens 12 π-Elektronen bedeuten.

Bevorzugte Reste A entsprechen der Formel

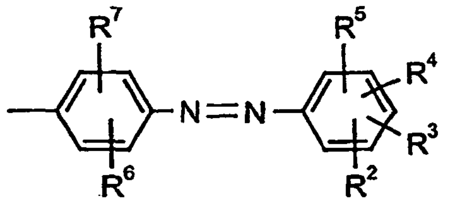

worin

$R^2$ bis $R^7$ unabhängig voneinander Wasserstoff, Hydroxyl, Halogen, Nitro, Cyan, $C_1$-$C_4$-Alkyl, $C_1$-$C_4$-Alkoxy, $CF_3$, $CCl_3$, $CBr_3$, $SO_2CF_3$, $C_1$-$C_6$-Alkylsulfonyl, Phenylsulfonyl, $C_1$-$C_6$-Alkylaminosulfonyl, Phenylaminosulfonyl, Aminocarbonyl, $C_1$-$C_6$-Akylaminocarbonyl, Phenylaminocarbonyl oder $COOR^1$ bedeuten.

Bevorzugte Reste M entsprechen der Formel

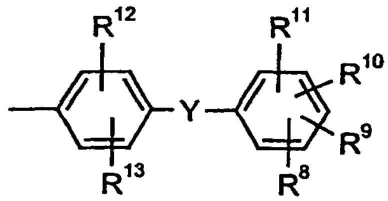

worin

$R^8$ bis $R^{13}$ unabhängig voneinander Wasserstoff, Hydroxyl, Halogen, Nitro, Cyan, $C_1$-$C_4$-Alkyl, $C_1$-$C_4$-Alkoxy, $CF_3$, $CCl_3$, $CBr_3$, $SO_2CF_3$, $C_1$-$C_6$-Alkylsulfonyl, Phenylsulfonyl, $C_1$-$C_6$-Alkylaminosulfonyl, Phenylaminosulfonyl, Aminocarbonyl, $C_1$-$C_6$-Alkylaminocarbonyl, Phenylaminocarbonyl oder $COOR^1$ und

Y -COO-, -OCO-, -CONH-, -NHCO-, -O-, -NH-, -N($CH_3$)- oder eine Einfachbindung

bedeuten.

Besonders gute Ergebnisse erhält man, wenn im Polymer (A) mindestens 10, bevorzugt mindestens 20, besonders bevorzugt mindestens 30, äußerst bevorzugt mindestens 50 Wiederholeinheiten enthalten sind.

Auch im Polymer (B) sollten mehrere Wiederholeinheiten vorhanden sein, mindestens 3, bevorzugt mindestens 5, besonders bevorzugt mindestens 10 und äußerst bevorzugt mindestens 20 Wiederholeinheiten enthalten sind.

Besonders bevorzugt sind Mischungen aus Polymer A und Polymer B, wobei Polymer A einheitlich aus den gleichen Monomereinheiten aufgebaut ist und Polymer B ebenso aus gleichen (aber entsprechend obiger Definition von A verschiedenen Monomereinheiten) aufgebaut ist.

Natürlich ist es von der vorliegenden Erfindung auch umfasst, dass mehr als 1 Polymer (A) und/oder (B) enthalten ist, wobei aber stets ein Polymer (B) enthalten ist, bei dem P für A steht.

Sehr gute Ergebnisse werden erzielt, wenn das Verhältnis der Summe der Monomere der Polymeren (B) zur Summe der Monomere der Polymeren (A) zwischen 1:1 und 1:10.000, bevorzugt zwischen 1:1 und 1: 5000, besonders bevorzugt zwischen 1:2 und 1:3000, ganz besonders bevorzugt zwischen 1:5 und 1:1500 und äußerst bevorzugt zwischen 1:10 und 1:1000 liegt.

Bevorzugt sind Mischpolymeren, in denen das Polymere (A) Methylmethacrylateinheiten enthält.

Beim Vorliegen von Polymeren (B) mit Elementen, die STQP tragen, werden gute Ergebnisse erzielt. Eine

verbesserte Ausführungsform besteht darin, dass das Polymer B mindestens 2 verschiedene Monomere enthält, die die allgemeine Formel [STQP] tragen, wobei mindesten eines dieser Monomere eine Farbstoffgruppe A, bevorzugt eine photoisomerisierbare Gruppe trägt. Besonders bevorzugt ist es dabei, dass diese photoisomerisierbare Gruppe eine Azogruppe ist. Ganz besonders bevorzugt hat diese Gruppe die Struktur der Formel (CIV).

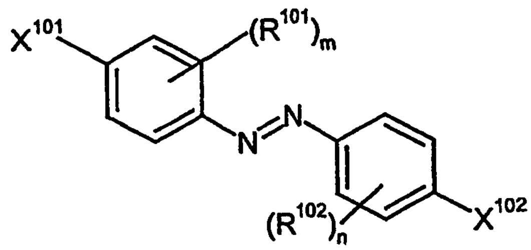

(CIV),

worin

$R^{101}$ und $R^{102}$ unabhängig voneinander für Wasserstoff oder einen nichtionischen Substituenten stehen,

m und n unabhängig voneinander für eine ganze Zahl von 0 bis 4, vorzugsweise 0 bis 2 stehen,

$X^{101}$ die Verbindung zu $S^{101}T^{101}Q^{101}$ darstellt, d.h. $X^{101}$ die Bedeutung $X^{101'}$hat, wobei $X^{101'}$ mit der 2. Valenz am Q gebunden ist,

$X^{102}$ $X^{102'}$-$R^{104}$ bedeutet,

$X^{101'}$ und $X^{102'}$ für eine direkte Bindung, -O-, -S-, -(N-$R^{105}$)-, -C($R^{106}R^{107}$)-, -(C=O)-, -(CO-O)-, -(CO-$NR^{105}$)-, -($SO_2$)-, -($SO_2$-O)-, -($SO_2$-$NR^{105}$)-, -(C=$NR^{18}$)- oder -($CNR^{18}$-$NR^{15}$)- stehen,

$R^{104}$, $R^{15}$ und $R^{18}$ unabhängig voneinander für Wasserstoff, $C_1$- bis $C_{20}$-Alkyl, $C_3$- bis $C_{10}$-Cycloalkyl, $C_2$- bis $C_{20}$-Alkenyl, $C_6$- bis $C_{10}$-Aryl, $C_1$- bis $C_{20}$-Alkyl-(C=O)-, $C_3$- bis $C_{10}$-Cycloalkyl-(C=O)-, $C_2$- bis $C_{20}$-Alkenyl-(C=O)-, $C_6$- bis $C_{10}$-Aryl-(C=O)-, $C_1$- bis $C_{20}$-Alkyl-($SO_2$)-, $C_3$- bis $C_{10}$-Cycloalkyl-($SO_2$)-, $C_2$- bis $C_{20}$-Alkenyl-($SO_2$)- oder $C_6$- bis $C_{10}$-Aryl-($SO_2$)- stehen oder

$X^{102'}$-$R^{104}$ für Wasserstoff Halogen, Cyan, Nitro, $CF_3$ oder $CCl_3$ stehen können,

$R^{106}$ und $R^{107}$ unabhängig voneinander für Wasserstoff, Halogen, $C_1$- bis $C_{20}$-Alkyl, $C_1$- bis $C_{20}$-Alkoxy, $C_3$- bis $C_{10}$-Cycloalkyl, $C_2$- bis $C_{20}$-Alkenyl oder $C_6$- bis $C_{10}$-Aryl stehen,

$S^{101}$ die Atome O, S oder den Rest $NR^{109}$ bedeutet,

$R^{109}$ Wasserstoff oder $C_1$-$C_4$ Alkyl bedeutet,

$T^{101}$ den Rest $(CH_2)_x$ bedeutet, der gegebenenfalls durch -O-, -$NR^{109}$- oder -$OSiR^{109}{}_2O$- unterbrochen und/oder durch Methyl oder Ethyl substituiert sein kann,

x die Zahlen 2, 3 oder 4 bedeutet,

$Q^{101}$ $Z^{101}$, $Z^{102}$ oder die Gruppe -$Z^{101}$-$X^{100}$-$Z^{102}$- bedeutet, worin

$Z^{101}$ und $Z^{102}$ unabhängig voneinander die Gruppen -S-, -$SO_2$-, -O-, -COO-, -OCO-, -$CONR^{109}$-, -$NR^{109}$CO-, -$NR^{109}$-, -N=N-, -CH=CH-, -N=CH-, -CH=N- oder die Gruppe -$(CH_2)_y$- mit y = 1 oder 2 bedeuten und

$X^{100}$ einen 5- oder 6-gliedrigen cycloaliphatischen, aromatischen oder heterocyclischen Ring, für den Fall $Z^{101}$ = -COO- oder -$CONR^{109}$- eine direkte Bindung oder die Gruppe -$(CH=CH)_y$- bedeutet,

wobei y die oben angegebene Bedeutung hat.

Unter nichtionischen Substituenten sind zu verstehen Halogen, Cyano, Nitro, $C_1$- bis $C_{20}$-Alkyl, $C_1$- bis $C_{20}$-Alkoxy, Phenoxy, $C_3$- bis $C_{10}$-Cycloalkyl, $C_2$- bis $C_{20}$-Alkenyl oder $C_6$- bis $C_{10}$-Aryl, $C_1$- bis $C_{20}$-Alkyl-(C=O)-, $C_6$- bis $C_{10}$-Aryl-(C=O)-, $C_1$- bis $C_{20}$-Alkyl-($SO_2$)-, $C_1$- bis $C_{20}$-Alkyl-(C=O)-O-, $C_1$- bis $C_{20}$-Alkyl-(C=O)-NH-, $C_6$-bis $C_{10}$-Aryl-(C=O)-NH-, $C_1$- bis $C_{20}$-Alkyl-O-(C=O)-, $C_1$- bis $C_{20}$-Alkyl-NH-(C=O)- oder $C_6$- bis $C_{10}$-Aryl-NH-(C=O)-.

Die Alkyl-, Cycloalkyl-, Alkenyl- und Arylreste können ihrerseits durch bis zu 3 Reste aus der Reihe Halogen, Cyano, Nitro, $C_1$- bis $C_{20}$-Alkyl, $C_1$- bis $C_{20}$-Alkoxy, $C_3$- bis $C_{10}$-Cycloalkyl, $C_2$- bis $C_{20}$-Alkenyl oder $C_6$- bis $C_{10}$-Aryl substituiert sein und die Alkyl- und Alkenylreste können geradkettig oder verzweigt sein.

Unter Halogen ist Fluor, Chlor, Brom und Iod zu verstehen, insbesondere Fluor und Chlor.

Bevorzugt sind Misch-Polymere, dadurch gekennzeichnet, dass die Monomere mit der photoisomerisierbaren Gruppe A die Formel (CV)

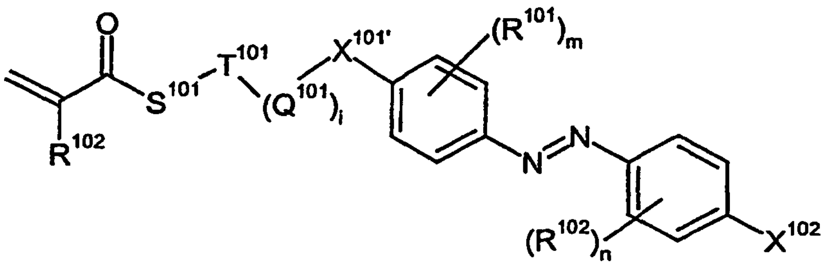

(CV),

aufweisen, worin

$R^{102}$ für Wasserstoff oder Methyl steht und

die anderen Reste die oben angegebene Bedeutung besitzen.

Besonders bevorzugte Monomere, die die photoisomerisierbare Gruppe A tragen, sind:

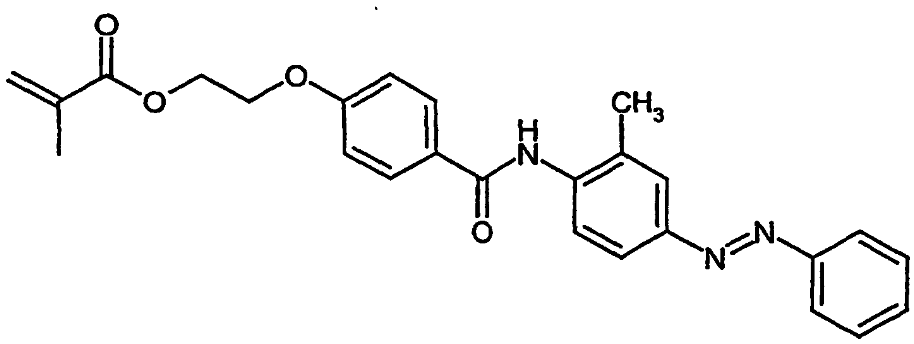

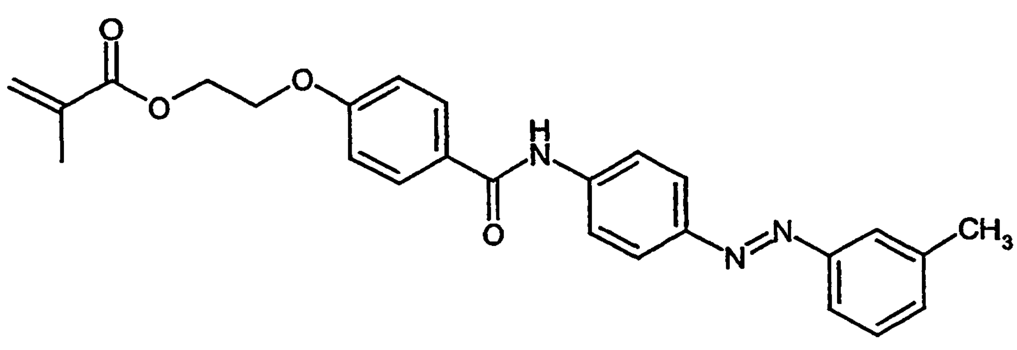

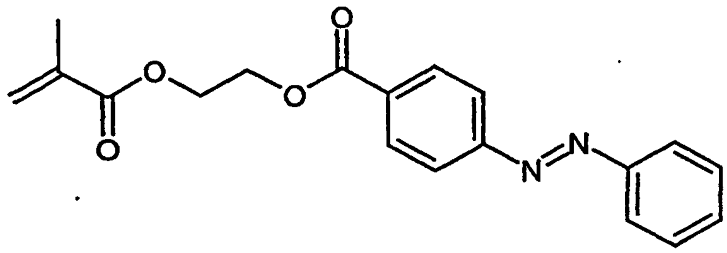

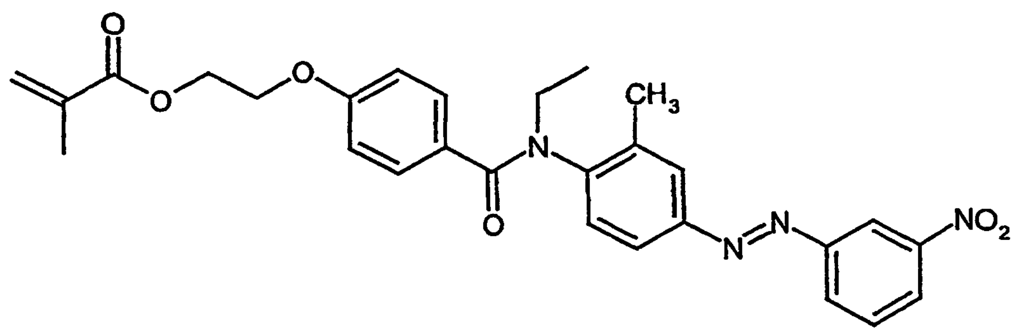

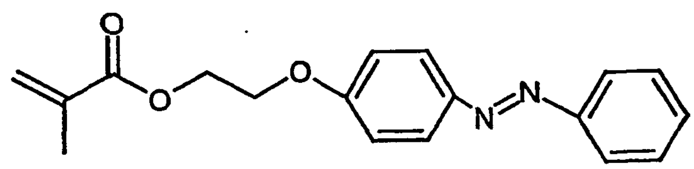

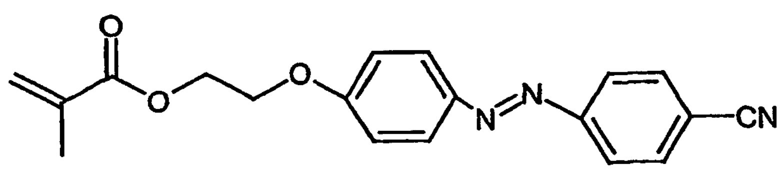

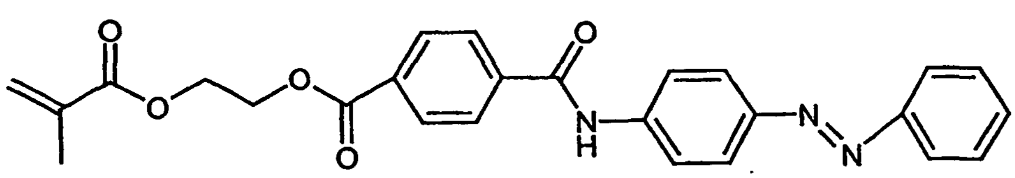

Ebenfalls bevorzugt sind Misch-Polymere, dadurch gekennzeichnet, dass sie neben Monomeren mit der photoisimerisierbaren Gruppe A, vorzugsweise solchen der Formel (CV), Monomere mit der polarisierbaren aromatischen

Gruppe M der Formel (CVI)

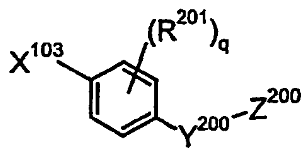

(CVI),

worin

$Z^{200}$ für einen Rest der Formeln

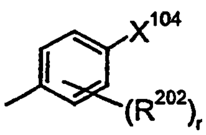

(CVIa)

oder

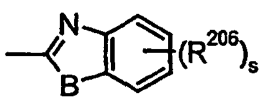

(CVIb)

steht,

worin

| | |
|---|---|
| B | für O, S oder N-$C_1$- bis $C_4$-Alkyl steht, |
| $X^{103}$ | für $-X^{103'}-(Q^{102})_j-T^{102}-S^{102}-$ steht, |
| $X^{104}$ | für $X^{104'}-R^{203}$ steht |
| $X^{103'}$ und $X^{104'}$ | unabhängig voneinander für eine direkte Bindung, -O-, -S-, $-(N-R^{205})-$, $-C(R^{206}R^{207})-$, -(C=O)-, -(CO-O)-, $-(CO-NR^{205})-$, $-(SO_2)-$, $-(SO_2-O)-$, $-(SO_2-NR^{205})-$, $-(C=NR^{208})-$ oder $-(CNR^{208}-NR^{205})-$ stehen, |
| $R^{205}$, $R^{208}$ und $R^{203}$ | unabhängig voneinander für Wasserstoff $C_1$- bis $C_{20}$-Alkyl, $C_3$-bis $C_{10}$-Cycloalkyl, $C_2$- bis $C_{20}$-Alkenyl, $C_6$- bis $C_{10}$-Aryl, $C_1$- bis $C_{20}$-Alkyl-(C=O)-, $C_3$- bis $C_{10}$-Cycloalkyl-(C=O)-, $C_2$- bis $C_{20}$-Alkenyl-(C=O)-, $C_6$- bis $C_{10}$-Aryl-(C=O)-, $C_1$- bis $C_{20}$-Alkyl-$(SO_2)$-, $C_3$- bis $C_{10}$-Cycloalkyl-$(SO_2)$-, $C_2$- bis $C_{20}$-Alkenyl-$(SO_2)$- oder $C_6$- bis $C_{10}$-Aryl-$(SO_2)$- stehen oder |
| $X^{104'}-R^{203}$ | für Wasserstoff, Halogen, Cyan, Nitro, $CF_3$ oder $CCl_3$ stehen kann, |
| $R^{206}$ und $R^{207}$ | unabhängig voneinander für Wasserstoff, Halogen, $C_1$- bis $C_{20}$-Alkyl, $C_1$- bis $C_{20}$-Alkoxy, $C_3$- bis $C_{10}$-Cycloalkyl, $C_2$- bis $C_{20}$-Alkenyl oder $C_6$- bis $C_{10}$-Aryl stehen, |
| $Y^{200}$ | für eine einfache Bindung, -COO-, OCO-, -CONH-, -NHCO-, $-CON(CH_3)-$, $-N(CH_3)CO-$, -O-, -NH- oder $-N(CH_3)-$ steht, |

$R^{201}$, $R^{202}$, $R^{206}$ unabhängig voneinander für Wasserstoff, Halogen, Cyano, Nitro, $C_1$-bis $C_{20}$-Alkyl, $C_1$- bis $C_{20}$-Alkoxy, Phenoxy, $C_3$- bis $C_{10}$-Cycloalkyl, $C_2$- bis $C_{20}$-Alkenyl oder $C_6$- bis $C_{10}$-Aryl, $C_1$- bis $C_{20}$-Alkyl-(C=O)-, $C_6$- bis $C_{10}$-Aryl-(C=O)-, $C_1$- bis $C_{20}$-Alkyl-($SO_2$)-, $C_1$- bis $C_{20}$-Alkyl-(C=O)-O-, $C_1$- bis $C_{20}$-Alkyl-(C=O)-NH-, $C_6$- bis $C_{10}$-Aryl-(C=O)-NH-, $C_1$- bis $C_{20}$-Alkyl-O-(C=O)-, $C_1$- bis $C_{20}$-Alkyl-NH-(C=O)- oder $C_6$- bis $C_{10}$-Aryl-NH-(C=O)- stehen,

q, rund s unabhängig voneinander für eine ganze Zahl von 0 bis 4, vorzugsweise 0 bis 2 stehen,

$Q^{102}$ für -O-, -S-, -(N-$R^{205}$)-, -C($R^{206}R^{207}$)-, -(C=O)-, -(CO-O)-, -(CO-$NR^{205}$)-, -($SO_2$)-, -($SO_2$-O)-, -($SO_2$-$NR^{205}$)-, -(C=$NR^{208}$)-, -($CNR^{208}$-$NR^{205}$)-, -$(CH_2)_p$-, p- oder m-$C_6H_4$- oder einen zweibindigen Rest der Formeln

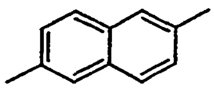

oder

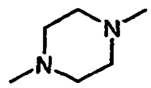

steht,

j für eine ganze Zahl von 0 bis 4 steht, wobei für j > 1 die einzelnen $Q^{102}$ verschiedene Bedeutungen haben können,

$T^{102}$ für -$(CH_2)_p$- steht, wobei die Kette durch -O-, -$NR^{209}$-, oder -$OSiR^{220}{}_2O$- unterbrochen sein kann,

$S^{102}$ für eine direkte Bindung, -O-, -S- oder -$NR^{209}$- steht,

p für eine ganze Zahl von 2 bis 12, vorzugsweise 2 bis 8, insbesondere 2 bis 4 steht,

$R^{209}$ für Wasserstoff, Methyl, Ethyl oder Propyl steht und

$R^{220}$ für Methyl oder Ethyl steht.

Bevorzugte Monomere mit solchen formanisotropen Gruppierungen M haben dann die Formel (CVII)

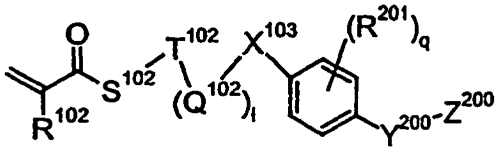

(CVII),

worin

$R^{102}$ für Wasserstoff oder Methyl steht und

die anderen Reste die oben angegebene Bedeutung besitzen.

Besonders bevorzugte formanisotrope Monomere der Formel (CVII) sind beispielsweise:

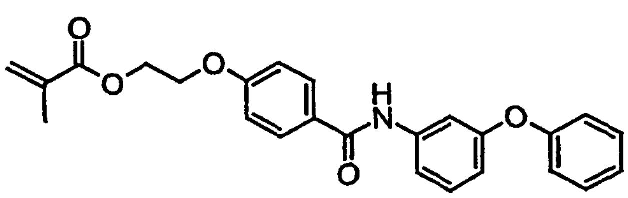

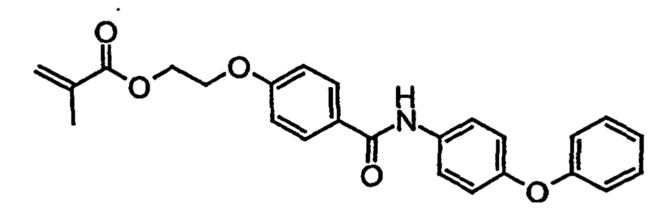

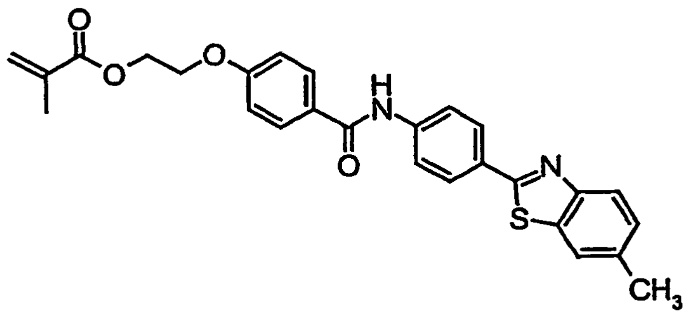

enthalten.

Die erfindungsgemäßen Mischpolymeren enthalten neben mindestens einem Polymeren (A)

a) vorzugsweise mindestens ein Polymer (B), das aus Monomeren der Formel (CV) besteht,
b) vorzugsweise mindestens ein Polymer (B), das aus Monomeren der Formel (CV) besteht und mindestens ein Polymer (B), das aus Monomeren der Formel (CVII) besteht,
c) besonders bevorzugt mindestens ein Polymer, das das aus Monomeren der Formel (CV) und Monomeren der Formel (CVII) besteht.

Im Falle a) können die Monomeren der Formel (CV) des Polymeres (B) gleich oder verschieden sein. Analoges gilt für die Monomeren (CV) und/oder (CVII) in den Polymeren (B) in den Fällen b) und c).

Die Monomeren der Formel (CV) und der Formel (CVII) werden in den erfindungsgemäßen Mischpolymeren im Verhältnis 1:1 bis 1:30, vorzugsweise 1:1 bis 1:20, besonders bevorzugt 1:2 bis 1:10 eingesetzt.

Die Polymeren (A) und (B) werden jedes für sich beispielsweise durch radikalische Polymerisation hergestellt. Die Mischpolymere werden durch Mischen der Einzelpolymeren in den gewünschten Mengenverhältnissen unter Erwärmen über die Glastemperatur hergestellt.

Ein wichtiger Parameter für die vorliegende Erfindung ist die optische Dichte, die bei der Wellenlänge des Schreiblasers und einer Probendicke von 1 mm einen Wert ≤ 2, vorzugsweise ≤ 1, besonders bevorzugt von ≤ 0,3 besitzt. Auf diese Art und Weise kann sichergestellt werden, dass das aktinische Licht zu einer homogenen Durchleuchtung des gesamten Speichermediums führt und ein dickes Hologramm erzeugt werden kann. Die optische Dichte kann mit kommerziellen UV-/VIS-Spektrometern (z.B. CARY, 4G) bestimmt werden.

Insbesondere handelt es sich bei dem erfindungsgemäßen Misch-Polymer um ein Material, das eine durchstrahlte Dicke von ≥ 0,1 mm, besonders 0,5 mm vorzugsweise ≥ 1 mm und ganz besonders bevorzugt nicht größer als 1 cm hat.

Bei der Gruppierung, die mit der elektromagnetischen Strahlung in Wechselwirkung tritt, handelt es sich bevorzugt um einen oben beschriebenen Farbstoff, welche bevorzugt im Wellenlängenbereich zwischen 390 bis 800 nm, besonders bevorzugt um den Bereich 400 bis 650 nm und ganz besonders bevorzugt im Bereich von 510 bis 570 nm absorbiert. Als typischer Testlaser kann ein Nd:YAG Laser ($\lambda$ = 532 nm) herangezogen werden.

Zum Lesen wird das Aufzeichnungsmaterial nicht mehr wie beim Schreiben zwei interferierenden Strahlen ausgesetzt, sondern nur noch einem Strahl, dem Lesestrahl.

Die Wellenlänge des Lesestrahls liegt vorzugsweise längerwellig als die von Signal- und Referenzwelle, beispielsweise 70 bis 500 nm längerwellig. Das Lesen mit der Wellenlänge des Schreiblasers ist jedoch ebenfalls möglich und wird insbesondere bei der kommerziellen Nutzung von holographischen Volumenspeichern zum Einsatz kommen. Hierzu wird beim Lesevorgang aber die Energie des Lesestrahls durch entweder die Reduzierung der Belichtungsintensität, oder der Belichtungszeit, oder durch eine Reduzierung der Belichtungsintensität und der Belichtungszeit herabgesetzt.

Die optische Dichte des erfindungsgemäßen Misch-Polymers wird durch die Konzentration des mindestens einen Farbstoffs in dem Polymerenmaterial bestimmt.

**Beispiele:**

**Beispiel 1 Herstellung der Monomere**

***1.1.***

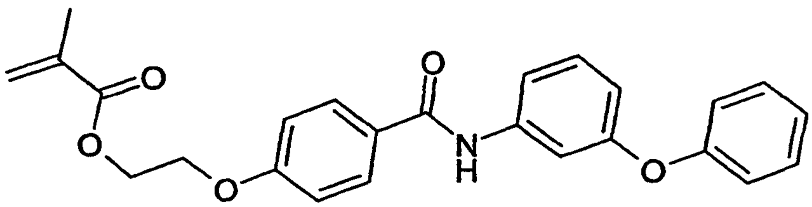

Zu einer Lösung von 125 g 4-(2-Methacryloyloxy)-ethoxy-benzoesäurechlorid in 200 ml Dioxan werden 85,9 g 3-Aminodiphenylether in 200 ml Dioxan gegeben, 2 h gerührt und das Produkt durch Eingießen der Lösung in 21 Wasser gefällt. Der Niederschlag wird abgesaugt, getrocknet und durch zweimaliges Umlaistallisieren aus Isopropanol gereinigt. Die Ausbeute beträgt 40 % d.Th. Fp. = 111°C.

| Elementaranalyse: $C_{25}H_{23}NO_5$ (417,47) | | | |
|---|---|---|---|
| Ber. | C71,93; | H5,55; | N3,36. |
| Gef. | C71,50; | H5,70 | N3,40. |

***1.2***

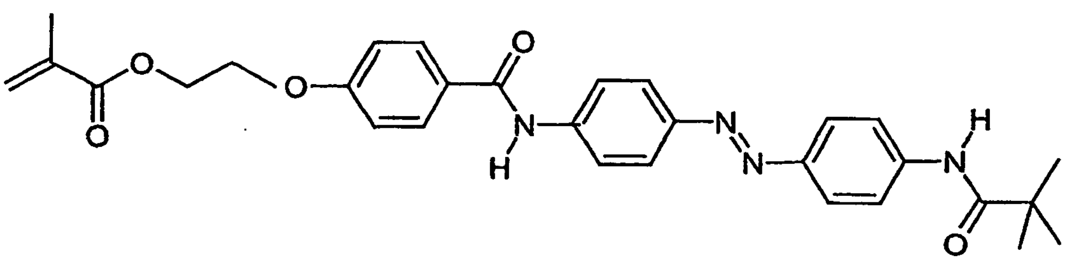

*a) 4-(2-Hydroxyethyloxy)benzoesäure*

138 g p-Hydroxybenzoesäure und 0,5 g KI werden unter Rühren in 350 ml Ethanol vorgelegt. Eine Lösung von 150 g KOH in 150 ml Wasser wird zugetropft. 88,6 g Ethylenchlorhydrin werden bei 30°- 60°C innerhalb von 30 Min zugetropft. Die Reaktionsmischung wird 15 h unter Rückfluß gerührt. Danach wird das Lösungsmittel zunächst unter Normaldruck und dann im Vakuum vollständig abdestilliert. Der Rückstand wird in 1l Wasser gelöst und mit HCl angesäuert. Niederschlag wird abgesaugt und aus 1,8 l Wasser umkristallisiert. Das Produkt wird getrocknet und zweimal aus Ethanol umkristallisiert. Die Ausbeute beträgt 46 g (25 % d. Th.). Fp. 179,5°C.

b) *4-(2-Methacryloyloxyethyloxy)benzoesäure*

45 g *4-(2-Hydroxyethyloxy)benzoesäure*, 180 ml Methacrylsäure 10 g p-Toluolsulfonsäure und 10 g Hydrochinon werden in 150 ml Chloroform unter Rühren am Rückfluß erhitzt. Das während der Reaktion entstehende Wasser

wird am Wasserabscheider abgetrennt. Die Reaktionsmischung wird mit 150 ml Chloroform verdünnt, mehrmals mit je 100 ml Wasser gewaschen und über $Na_2SO_4$ getrocknet. Das Trockenmittel wird abfiltriert, und das Chloroform am Rotationsverdampfer auf zwei Drittel abdestilliert. Das Produkt fällt aus, wird abgesaugt und zweimal aus Isopropanol umkristallisiert. Die Ausbeute beträgt 28 g (45 % d.Th.). Fp. 146°C.

c) *4-(2-Methacryloyloxyethyloxy)benzoesäurechlorid*

25 g *4-(2-Methacryloyloxyethyloxy)benzoesäure*, 80 ml Thionylchlorid und 0,5 ml DMF werden bei Raumtemperatur 30 Min gerührt. Überschüssiges Thionylchlorid wird danach zunachst im mäßigen Vakuum und dann im Hochvakuum abdestilliert. Das dabei entstandene Säurechlorid mit fast quantitativer Ausbeute krisallisiert nun bei Raumtemperatur langsam aus.

| Elementaranalyse: $C_{13}H_{13}ClO_4$ (268,7) | | | |
|---|---|---|---|
| Ber. | C58,11; | H4,88; | Cl13,19; |
| Gef. | C58,00; | H4,90; | Cl13,20. |

d) *4-Pivalinoylamino-4'-aminoazobenzol*

36 g *4,4'-Diaminoazobenzol* und 62 g Triethylamin werden in 400 ml THF vorgelegt. Eine Lösung von 23,2 g Pivalinsäurechlorid in 100 ml THF wird langsam zugetropft. Nach 2 h rühren bei Raumtemperatur wird die Reaktionsmischung mit Wasser versetzt. Der Niederschlag wird abfiltriert und getrocknet. Man erhält 42 g des Produktes. Weitere Reinigung erfolgt chromatographisch (Kieselgel; Toluol/Ethylacetat 1:1). Die Ausbeute beträgt 8 g. Fp. 230°C.

e) *4-Pivalinoylamino-4'-[p-(2-methacryloyloxy-ethyloxy)bezoylamino]azobenzol*

1 g *4-Pivalinoylamino-4'-aminoazobenzol* wird in 10 ml N-Methyl-2-pyrrolidon (NMP) bei 50°C vorgelegt und zu der Lösung von 1 g *4-(2-Methacryloyloxyethyloxy)-benzoesäure* in 1 ml NMP bei 50°C zugegeben. Die Reaktionsmischung wird bei dieser Temperatur 1 h gerührt, abgekühlt, mit 200 ml Wassser versetzt. Der Niederschlag wird abfiltriert, in 30 ml Methanol bei Raumtemperatur nachgerührt, von der Mutterlauge abfiltriert und im Vakuum getrocknet. Die Ausbeute beträgt 1,2 g. Fp 194°C. $\lambda_{max}$ = 378 nm (DMF) $\varepsilon$ = 37000 l/(mol*cm).

**Beispiel 2 Herstellung der Homopolymere**

7,5 g Monomer 1.1 und 0,15g 2,2'Azoisobuttersäuredinitril wurden in 70 ml DMF in der Argonatmosphäre 24 h bei 70°C geruhrt. Das Polymer wird durch Eingießen der Lösung in 200 ml Wasser ausgefallen und durch Aufkochen in Methanol gereinigt.

**Beispiel 3 Herstellung der Copolymere**

0,8 g Monomer 1.1, 0,632 g Monomer 1.2 und 0,03 g 2,2'Azoisobuttersäuredinitril wurden in 15 ml DMF in der Argonatmosphäre 24 h bei 70°C gerührt. Das Copolymer wird durch Eingießen der Lösung in 200 ml Wasser ausgefallen und durch Aufkochen in Methanol gereinigt.

Die erfindungsgemäßen Mischpolymere lassen sich ausgezeichnet zur Herstellung von optischen Elementen und Speicher nutzen, die bevorzugt zur Speicherung von Daten eingesetzt werden, wobei besonders bevorzugt Holographie eingesetzt wird.

Dies begründet sich dadurch, dass mittels eines Laserstrahls sehr gut Information in das optische Element eingeschrieben werden kann.

Bevorzugter Gegenstand der Anmeldung sind Volumenspeicher enthaltend mindestens ein erfindungsgemäßen Mischpolymer, die eine durchstrahlte Dicke von ≥ 0,1 mm bevorzugt > 0,5, mm besonders bevorzugt >1,0 mm, ganz besonders bevorzugt zwischen 1 mm und 1 cm besitzen.

Die Herstellung von Volumenspeichern in Form von Filmen, Folien, Platten und Quadern gelingt, ohne dass aufwendige Orientierungsverfahren unter Nutzung externer Felder und/oder von Oberflächeneffekten notwendig sind. Sie lassen sich durch Spincoaten, Tauchen, Gießen oder andere technologisch leicht beherrschbare Beschichtungsverfahren auf Unterlagen aufbringen, durch Pressen oder Einfließen zwischen zwei transparente Platten bringen oder einfach als selbsttragendes Material durch Gießen oder Extrudieren präparieren. Solche Filme, Folien, Platten und Quader lassen sich durch schlagartiges Abkühlen, d. h. durch eine Abkühlungsrate von > 100 K/min, oder durch rasches Abziehen des Lösungsmittels auch aus flüssigkristallinen Polymeren oder Oligomeren herstellen, die Strukturelemente

im beschriebenen Sinne enthalten.

Die Schichtdicke ist ≥ 0,1 mm, vorzugsweise ≥ 0,5 mm besonders bevorzugt ≥ 1 mm. Ein besonders bevorzugtes Präparationsverfahren für Schichten im Millimeterbereich stellt das Spritzgussverfahren dar. Hierbei wird die Polymerschmelze durch eine Düse in eine formgebende Halterung gepresst, aus der sie nach dem Abkühlen entnommen werden kann. Gegenstand der Anmeldung sind auch Volumenspeicher, die durch eine Schutzschicht gegen mechanische Beschädigung geschützt sind.

Die Methode der holographischen Datenspeicherung ist beispielsweise in LASER FOCUS WORLD, NOVEMBER 1996, Seite 81 ff. beschrieben.

Beim Schreiben eines Hologramms werden die oben beschriebenen Polymerfilme von zwei kohärenten Laserstrahlen einer Wellenlänge, die die erforderlichen lichtinduzierten Reorientierungen hervorruft, bestrahlt. Der eine Strahl, der Objektstrahl enthält die zu speichernde optische Information, beispielsweise den Intensitätsverlauf, der aus dem Durchgang eines Lichtstrahls durch eine zweidimensionale, schachbrettartige Pixelstruktur (Datenseite) resultiert. Im Prinzip kann jedoch Licht, das von jedem beliebigen zwei oder dreidimensionale Objekte gebeugt, gestreut, oder reflektiert wird, als Objektstrahl herangezogen werden. Auf dem Speichermedium wird der Objektstrahl mit dem zweiten Laserstrahl, dem Referenzstrahl, der im allgemeinen eine ebene oder zirkulare Welle ist, zur Interferenz gebracht. Das resultierende Interferenzmuster prägt sich im Speichermedium als Modulation der optischen Konstanten (Brechungsindex und/oder Absorptionskoeffizient) ein. Diese Modulation durchsetzt den gesamten bestrahlten Bereich, insbesondere die Dicke des Speichermediums. Wird nun der Objektstrahl abgeblockt und das Medium einzig mit dem Referenzstrahl belichtet, so fungiert das modulierte Speichermedium als eine Art Beugungsgitter für den Referenzstrahl. Die durch die Beugung resultierende Intensitätsverteilung entspricht der Intensitätsverteilung, die vom zu speichernden Objekt ausging, so dass nicht mehr unterschieden werden kann, ob das Licht vom Objekt selber kommt, oder ob es aufgrund der Beugung des Referenzstrahles resultiert.

Zum Abspeichern verschiedener Hologramme an einer Probenposition verwendet man unterschiedliche Multiplexverfahren: Wellenlängenmultiplexing, Shiftmultiplexing, Phasenmultiplexing, Peristrophic Multiplexing und/oder Winkelmultiplexing. Beim Winkelmultiplexing ändert man den Winkel zwischen dem Speichermedium, in dem unter den aktuellen Winkeln ein Hologramm gespeichert wurde und dem Referenzstrahl. Ab einer gewissen Winkeländerung verschwindet das ursprüngliche Hologramm (Bragg-Mismatch): der einfallende Referenzstrahl kann nicht mehr vom Speichermedium zur Rekonstruktion des Objektes abgelenkt werden. Der Winkel, ab dem dies geschieht, hängt entscheidend von der Dicke des Speichermediums (und von der im Medium erzeugten Modulation der optischen Konstanten) ab: Je dicker das Medium, umso geringer ist der Winkel, um dem der Referenzstahl geändert werden muss.

In dieser neuen Winkelkonfiguration kann ein weiteres Hologramm eingeschrieben werden. Das Auslesen dieses Hologramms funktioniert wieder genau in der Winkelkonfiguration zwischen Speichermedium und Referenzstrahl, in der es auch geschrieben wurde.

Durch sukzessive Änderung der Winkel zwischen Medium und Schreibstrahlen können somit mehrere Hologramme an der gleichen Stelle des Speichermediums eingeschrieben werden.

Gegenstand der Anmeldung sind alle in den Patentansprüchen beschriebenen Polymere, Verfahren und Verwendungen.

Gegenstand der Anmeldung ist ein Verfahren zur Herstellung von optischen Elementen und Speicherelementen, bevorzugt holografische Volumenspeicher, durch Spritzguss.

Gegenstand der Anwendung ist ein Verfahren zur Herstellung von optischen Elementen und Speicherelementen, bevorzugt holografische Volumenspeicher durch Spritzguss, wobei zusätzlich der Formkörper poliert wird.

Eine Polierung der Formkörper erfolgt solange bis die Wellenfrontverzerrung und die Oberflächenphenorität besser als $\frac{\lambda}{10}$ ist. Die Wellenfrontverzerrung wird durch die Abbildung des Formkörpers auf z.B. eine CCD-Kamera während dessen Belichtung mit einem Strahl des Schreiblasers der Wellenlänge $\lambda$ bestimmt

Gegenstand der Anmeldung ist ein Verfahren zur Herstellung von optischen Elementen und Speicherelementen, bevorzugt holographische Volumenspeicher durch Spritzguss, wobei zusätzlich eine transparente Schutzschicht aufgebracht wird.

Gegenstand der Anmeldung sind erfindungsgemäße optische Elemente und Speicher, bevorzugt Volumenspeicher, besonders bevorzugt holographische Volumenspeicher.

## Beispiele

**Beispiel 4** Probenpräparation Polymermischung B 1

Polymermischung B 1 ist eine Mischung zwischen einem Polymer

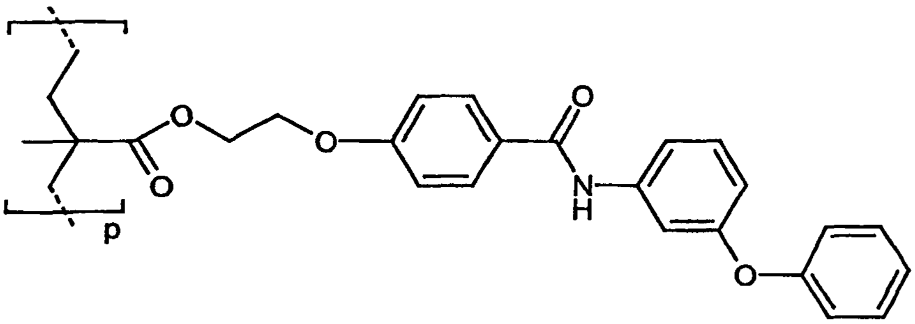

1

und einem Polymer der Formel 2

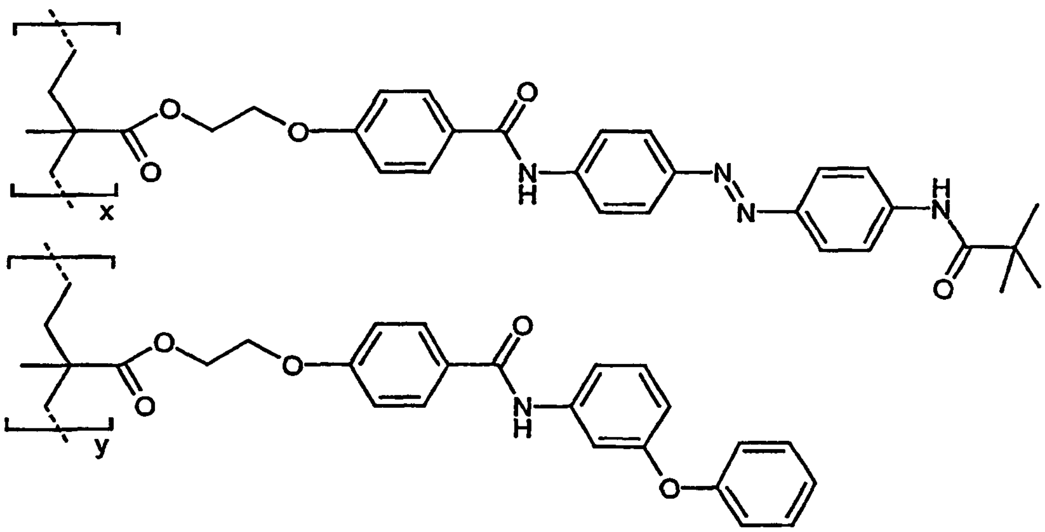

2

Nach der Herstellung werden beiden Polymere in fester Phase derart gemischt, dass die durchschnittliche Konzentration der Azobenzoleinheit x im Gemisch 1 mol-% (bezogen auf die Summe x + y + p) beträgt. Das Gemisch wird zum Ausgasen im Vakuum auf 180°C erwärmt. Hierbei geht es in die flüssige Phase über. In dieser Phase kann das Gemisch zwischen 2 Glasplättchen gepresst werden. Hierzu wird ein Polymertropfen des Polymers auf ein Glassubstrat (Dimension: 2,5 cm x 2,5 cm) gelegt. Am Rande der Glassubstrate befinden sich dünne PET-Plastikstreifen. Auf den Polymertropfen wird ein weiteres Glassubstrat gelegt. Ein schweres Metallgewicht wird auf das obere Deckglas gestellt und dient als Pressgewicht. Das Sandwich Glassubstrat-Polymer-Glassubstrat wird unter dem Druck des Gewichtes für ca. 1 Stunde bei 180°C im Vakuum gelagert. Nach dem Pressen und Abkühlen der Probe wird die Dicke des Sandwiches Glas-Polymer-Glas gemessen: Hieraus ergibt sich eine Dicke des Polymerfilms von 137 µm. Der Film ist optisch transparent und nicht streuend. Bei einer Wellenlänge von 532 nm wird mit einem UV/VIS-Spektrometer eine optische Dichte des Polymers von OD (532 nm) = 0,15 gemessen.

**Beispiel 5** Probenpräparation Polymermischung 2

Nach der Herstellung wird die Polymermischung B2 der Formel 2 mit einer Azobenzolkonzentration x = 1 mol-% zum Ausgasen im Vakuum auf 180°C erwärmt. Die weitere Probenpräparation erfolgt wie im Beispiel 1. Nach dem Pressen im Vakuum resultiert eine Filmdicke von 156 µm. Bei einer Wellenlänge von 532 nm wird mit einem UV/VIS-Spektrometer eine optische Dichte des Polymers von OD (532 nm) = 0,15 gemessen.

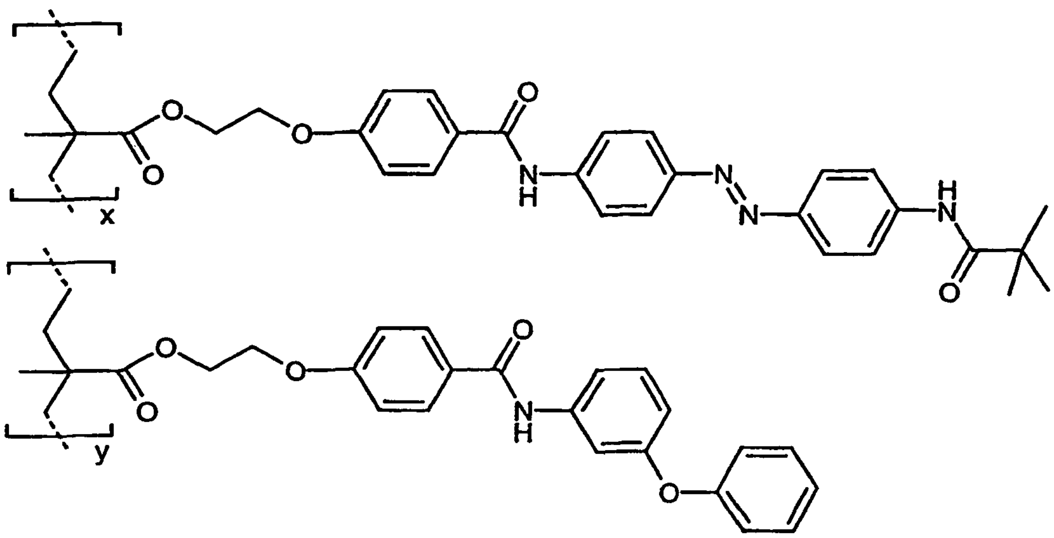

**Beispiel 6** Holographische Untersuchungen an Polymermischungen B1 und B2 aus Beispiel 1 und 2

In einem holographischen Experiment wird ein Hologramm einer Datenmaske mit 256 x 256 Datenpunkte aufgezeichnet. Die Wellenlänge des verwendeten Lasers beträgt $\lambda$ = 532 nm. Die Leistungsdichte des Objektstrahles am Probenort beträgt 2,8 $mW/cm^2$, die Leistungsdichte des Referenzstrahles beträgt 134,3 $mW/cm^2$. Hieraus errechnet sich ein halographisches Kontrastverhältnis m von m = 0,28. Die Belichtungszeit mit beiden Schreiblasern beträgt jeweils 60 Sekunden. Danach werden die Hologramme bei abgeblocktem Objektstrahl mit dem Referenzstrahl für 5 Millisekunden ausgelesen. Aus dem Verhältnis der einfallenden Lichtleistung $I_{ein}$ des Referenzstrahls und der am Detektor (in diesem Falle CCD-Kamera) gemessenen Intensität $I_{abg}$ berechnet sich die Beugungseffizienz $\eta = I_{abg}/I_{ein}$. Aus dieser Größe läßt sich die materialspezifische Größe $(\eta)^{1/2}$/(Dicke) ableiten, die proportional zur lichtinduzierten Brechungsindexmodulation ist. Ferner kann aus der zeitlichen Entwicklung der Beugungseffizienz die Lichtempfindlichkeit S des Materials als Steigung der holographischen Wachstumskurve bestimmt werden:

$$S = \frac{\partial\sqrt{\eta}}{\partial E}\frac{1}{d}$$

$\partial$ steht für die Ableitung, E ist die deponierte Schreibenergie (Schreibleistung x Belichtungszeit) und d für die Dicke der Proben.

Die folgende Tabelle vergleicht die gemessenen Resultate an Polymer 1 und Polymer 2.

| Polymer | Dicke d ($\mu$m) | OD @ $\lambda_{schreib}$ | $\eta$ | $(\eta_{max})^{1/2}$/d ($\mu m^{-1}$) | S (cm/J) |
|---|---|---|---|---|---|
| Polymermischung 1 | 137 | 0,15 | $7 \times 10^{-5}$ | $6{,}11 \times 10^{-5}$ | 0,089 |
| Polymennischung 2 | 156 | 0,15 | $5 \times 10^{-6}$ | $1{,}43 \times 10^{-5}$ | 0,024 |

Die Tabelle zeigt, dass die Polymermischung B1 sowohl eine höhere Beugungseffizienz $\eta$ und somit eine höhere Brechungsindexmodulation erlaubt, als auch lichtempfindlicher ist, also einen höheren Wert S besitzt.

**Beispiel 7** Trübungsuntersuchungen an Polymermischungen

Zur quantitativen Analyse der Mischbarkeit verschiedener Polymerer werden Lichtstreuexperimente an 1:1 Mischungen von folgenden Polymeren durchgeführt. Polymermischung B3 ist ein 1:1 Gemisch aus einem Polymer der Formel 3

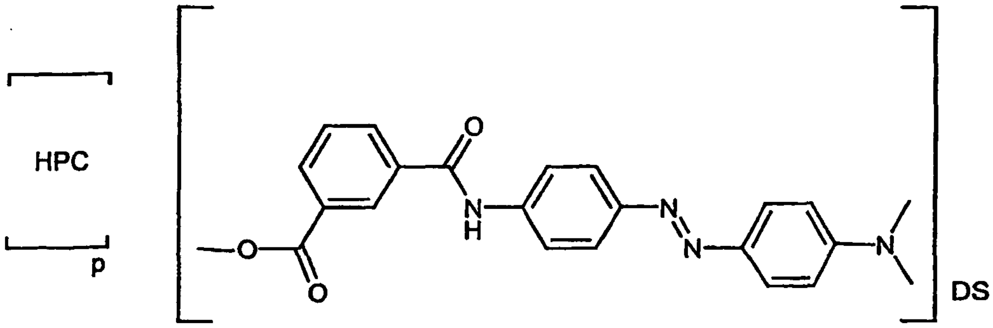

3

und einem Polymer der Formel 4

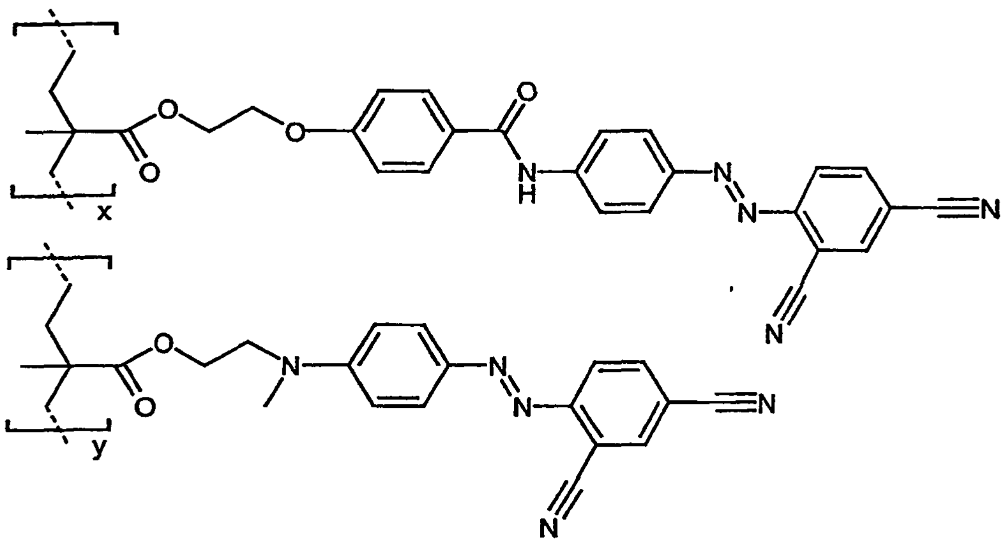

4

Polymermischung B4 ist eine 1:1 Gemisch eines Polymers der Formel 3 (p=3000) und einem Polymer **5**

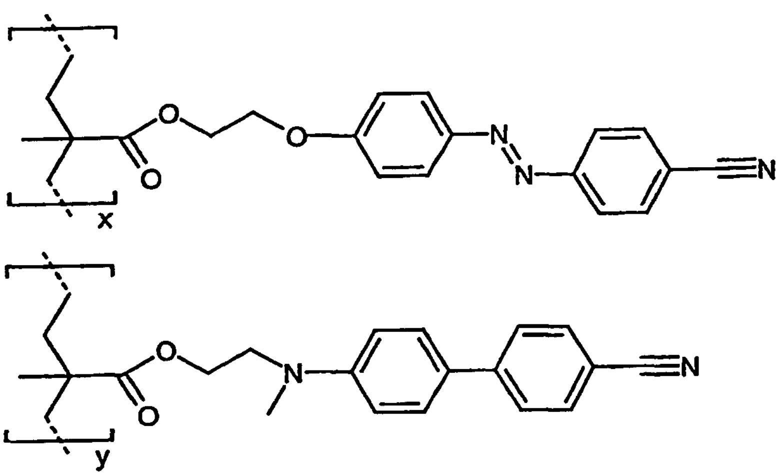

5

Zur Herstellung des Polymergemisches werden die jeweiligen Bestandteile zu gleichen Gewichtsanteilen in THF gelöst und mittels Spincoating auf Glassubstrate aufgebracht. Es entstehen Filme einer dicke von ca. 1 µm.

Als quantitative Meßgröße bei Trübungsuntersuchungen wird der sogenannte HazeWert angegeben. Dieser Wert stellt den Anteil des gestreuten transmittierten Lichtes bezogen auf die insgesamt transmittierte Lichtmenge dar.

$$\text{Haze} = \frac{\text{Streulicht (Transmission)}}{\text{Gesamttransmission}}$$

Streuung bzw. Trübung der Polymere tritt im Falle der Mischungen dann auf, falls die separierten Phasen eine Ausdehnung im Bereich der Lichtwellenlänge besitzen. Um die Absorptionsunterschiede der Polymerfilme zu berücksichtigen, werden die Messungen spektral durchgeführt. Es muss berücksichtigt werden, dass im blau-grünen Spektralbereich auch das gestreute Licht aufgrund der hohen Absorption der Probe bereits in der Probe absorbiert wird und nicht zum angemessenen Streulicht beiträgt. Konkret bedeutet dies, dass aufgrund der Eigenabsorption der Chromophore im blau-grünen Spektralbereich die Haze-Werte in einem Spektralbereich durchgeführt werden müssen, der außerhalb der Absorptionsbanden der untersuchten Chromophorsysteme liegt, in diesem Fall bei Wellenlängen größer als 630 nm.

Der Trübungswert von Polymermischung B3 liegt über den gesamten grün/roten Spektralbereich bei Haze ≈ 0,3, während das Polymergemisch B4 Hazewerte zwischen 4 und 8,5 liefert. Als Referenz sei der Hazewert bei $\lambda$ = 630 nm angeführt, da bei dieser Wellenlänge die verwendeten Filme eine vergleichbare Gesamtabsorption besitzen: Der Hazewert von Polymermischung B4 ist um den Faktor 20 größer als der Hazewert von Polymermischung B3.

Dies unterstreicht, dass aufgrund der Ähnlichkeit der Seitenketten in den Einzelkomponenten von Polymermischung B3 (jeweils 3-Kernkomponenten) eine homogene Mischung erfolgt, während bei Polymermischung B4 die Mischung insofern nicht perfekt erfolgt, als sich Phasen einer Ausdehnung im Bereich der Lichtwellenlänge ausbilden, die als Ursache für die Streuung betrachtet werden müssen.

## Patentansprüche

1. Misch-Polymer, **dadurch gekennzeichnet, dass** es aus mindestens einem Polymer (A) mit mindestens 10 Wiederholeinheiten der allgemeinen Formel (CI)

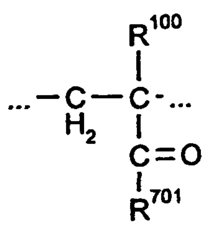

(CI),

worin

$R^{100}$ für Wasserstoff oder Methyl und

$R^{701}$ für -O-$R^{801}$, wobei

$R^{801}$ für Wasserstoff oder $C_1$-$C_8$ linear oder verzweigt Alkyl ohne fotoisomerisierbare Gruppe, bevorzugt Methyl, Ethyl, Propyl, n-Butyl, besonders bevorzugt Methyl steht, und

mindestens einem Polymer (B) mit mindestens 3 Wiederholeinheiten der allgemeinen Formel (CII)

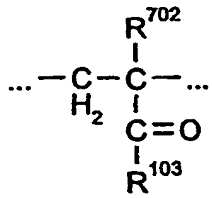

(CII)

besteht, wobei

$R^{702}$ für Wasserstoff oder Methyl und
$R^{103}$ für [-S-T-Q-P] steht und wobei P für A und/oder M steht,

wobei aber stets ein Polymer (B) enthalten ist, bei dem P für A steht,
wobei für die von der Hauptkette abzweigende Seitenkette der Formel S-T-Q-P mit P = A (Farbstoffgruppe), M (Mesogen) die folgenden allgemeinen Definitionen gelten:

$$S\text{-}T\text{-}Q\text{-}P = S^1 - T^1 - Q^1 - A$$

$$S\text{-}T\text{-}Q\text{-}P = S^2 - T^2 - Q^2 - M$$

wobei

$S^1$, $S^2$ unabhängig voneinander die Atome O, S oder den Rest $NR^1$ ,

$R^1$ Wasserstoff oder $C_1$-$C_4$-Alkyl,

$T^1$ , $T^2$ unabhängig voneinander den Rest $(CH_2)_n$, der gegebenenfalls durch -O-, -$NR^1$- oder -$OSiR^1{}_2O$- unterbrochen und/oder durch Methyl oder Ethyl substituiert sein kann,

n die Zahlen 2, 3 oder 4,

$Q^1$, $Q^2$ einen zweibindigen Rest,

A eine Einheit, die elektromagnetische Strahlung absorbieren kann, und

M eine polarisierbare aromatische Gruppe mit wenigstens 12 $\pi$-Elektronen bedeuten.

2. Misch-Polymer nach Anspruch 1, **dadurch gekennzeichnet, dass** im Polymer (A) mindestens 10 Wiederholeinheiten enthalten sind.

3. Misch-Polymer nach Anspruch 1 und/oder 2, **dadurch gekennzeichnet, dass** im Polymer (B) mindestens 3 Wiederholeinheiten enthalten sind.

4. Misch-Polymer nach einem oder mehreren der Ansprüche 1 bis 3, **dadurch gekennzeichnet, dass** mehr als 1 Polymer (A) und/oder (B) enthalten ist, wobei aber stets ein Polymer (B) enthalten ist, bei dem P für A steht.

5. Misch-Polymer nach einem oder mehreren der Ansprüche 1 bis 4 **dadurch gekennzeichnet, dass** das Verhältnis der Summe der Monomere des Polymeren (B) zur Summe der Monomere des Polymeren (A) zwischen 1:1 und 1:10.000, liegt.

6. Misch-Polymer nach einem oder mehreren der Ansprüche 1 bis 5, **dadurch gekennzeichnet, dass** Polymer (A) Methylmethacrylateinheiten enthält.

7. Misch-Polymer nach einem oder mehreren der Ansprüche 1 bis 6, **dadurch gekennzeichnet, dass** Polymer (B)

mindestens 2 verschiedene Monomeren der allgemeinen Formel [-S-T-Q-P] enthält, wobei mindesten eines dieser Monomere eine fotoisomerisierbare Gruppe A trägt.

8. Misch-Polymer nach einem oder mehreren der Ansprüche 1 bis 7, **dadurch gekennzeichnet, dass** Polymer (B) ein Monomer enthält, bei dem die fotoisomerisierbare Gruppe A eine Azogruppe ist

9. Misch-Polymer nach einem oder mehreren der Ansprüche 1 bis 8, **dadurch gekennzeichnet, dass** die fotoisomerisierbare Gruppe A die Struktur (CIV)

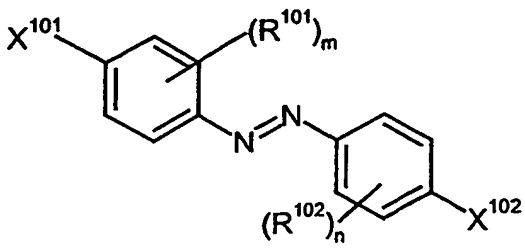

(CIV)

hat,
worin

| | |
|---|---|
| $R^{101}$ und $R^{102}$ | unabhängig voneinander für Wasserstoff oder einen nichtionischen Substituenten stehen, |
| m und n | unabhängig voneinander für eine ganze Zahl von 0 bis 4, vorzugsweise 0 bis 2 stehen, |
| $X^{101}$ | die Verbindung zu $S^{101}T^{101}Q^{101}$ darstellt, d.h. $X^{101}$ die Bedeutung $X^{101'}$hat, wobei $X^{101'}$ mit der 2. Valenz am Q gebunden ist, |
| $X^{102}$ | $X^{102'}$-$R^{104}$ bedeutet, |
| $X^{101'}$ und $X^{102'}$ | für eine direkte Bindung, -O-, -S-, -(N-$R^{105}$)-, -C($R^{106}R^{107}$)-, -(C=O)-, -(CO-O)-, -(CO-N$R^{105}$)-, -($SO_2$)-, -($SO_2$-O)-, -($SO_2$-N$R^{105}$)-, -(C=N$R^{18}$)- oder -(CN$R^{18}$-N$R^{15}$)- stehen, |
| $R^{104}$, $R^{15}$ und $R^{18}$ | unabhängig voneinander für Wasserstoff, $C_1$- bis $C_{20}$-Alkyl, $C_3$- bis $C_{10}$-Cycloalkyl, $C_2$- bis $C_{20}$-Alkenyl, $C_6$- bis $C_{10}$-Aryl, $C_1$- bis $C_{20}$-Alkyl-(C=O)-, $C_3$- bis $C_{10}$-Cycloalkyl-(C=O)-, $C_2$- bis $C_{20}$-Alkenyl-(C=O)-, $C_6$- bis $C_{10}$-Aryl-(C=O)-, $C_1$- bis $C_{20}$-Alkyl-($SO_2$)-, $C_3$- bis $C_{10}$-Cycloalkyl-($SO_2$)-, $C_2$- bis $C_{20}$-Alkenyl-($SO_2$)- oder $C_6$-bis $C_{10}$-Aryl-($SO_2$)- stehen oder |
| $X^{102'}$-$R^{104}$ | für Wasserstoff, Halogen, Cyan, Nitro, $CF_3$ oder $CCl_3$ stehen können, |
| $R^{106}$ und $R^{107}$ | unabhängig voneinander für Wasserstoff, Halogen, $C_1$- bis $C_{20}$-Alkyl, $C_1$- bis $C_{20}$-Alkoxy, $C_3$- bis $C_{10}$-Cycloalkyl, $C_2$- bis $C_{20}$-Alkenyl oder $C_6$- bis $C_{10}$-Aryl stehen, |
| $S^{101}$ | die Atome O, S oder den Rest N$R^{109}$ bedeutet, |
| $R^{109}$ | Wasserstoff oder $C_1$-$C_4$-Alkyl bedeutet, |
| $T^{101}$ | den Rest $(CH_2)_x$ bedeutet, der gegebenenfalls durch -O-, -N$R^{109}$- oder -OSi$R^{109}{}_2$O- unterbrochen und/oder durch Methyl oder Ethyl substituiert sein kann, |
| x | die Zahlen 2, 3 oder 4 bedeutet, |
| $Q^{101}$ | $Z^{101}$, $Z^{102}$ oder die Gruppe -$Z^{101}$-$X^{100}$-$Z^{102}$- bedeutet, worin |
| $Z^{101}$ und $Z^{102}$ | unabhängig voneinander die Gruppen -S-, -$SO_2$-, -O-, -COO-, -OCO-, -CON$R^{109}$-, -N$R^{109}$CO-, -N$R^{109}$-, -N=N-, -CH=CH-, -N=CH-, -CH=N- oder die Gruppe -$(CH_2)_y$- mit y = 1 |

oder 2 bedeuten und

$X^{100}$ einen 5- oder 6-gliedrigen cycloaliphatischen, aromatischen oder heterocyclischen Ring, für den Fall $Z^{101}$ = -COO- oder $-CONR^{109}-$ eine direkte Bindung oder die Gruppe $-(CH=CH)_y-$ bedeutet,

wobei y die oben angegebene Bedeutung hat.

**10.** Misch-Polymer nach einem oder mehreren der Ansprüche 1 bis 9, **dadurch gekennzeichnet, dass** die Monomere, die eine photoisomerisierbare Gruppe tragen, die Formel (CV)

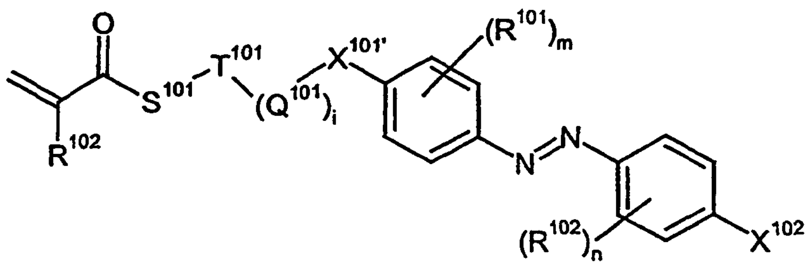

(CV),

besitzen,
worin

$R^{102}$ für Wasserstoff oder Methyl steht und

die anderen Reste die oben angegebene Bedeutung besitzen.

**11.** Misch-Polymere gemäß Anspruch 10, wobei Monomere, die photoisomerisierbare Gruppen tragen, ausgewählt sind aus den Strukturen

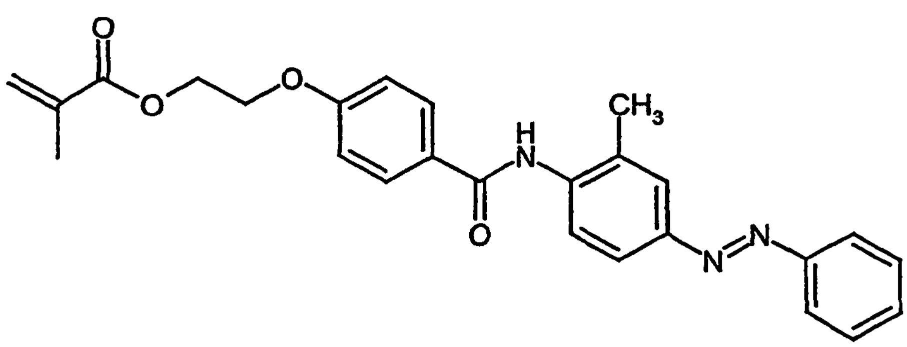

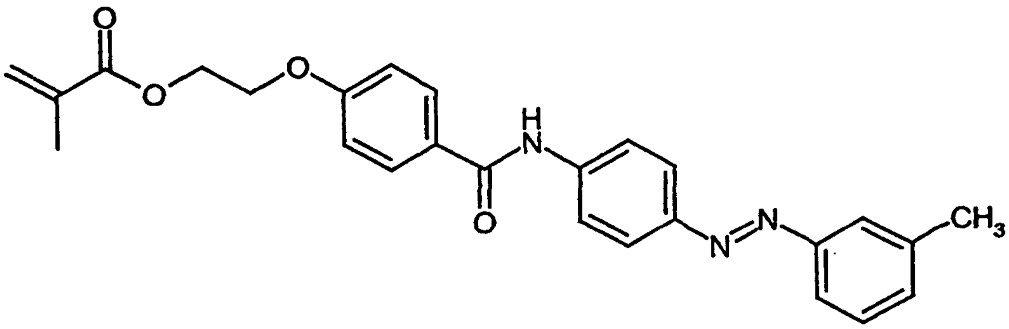

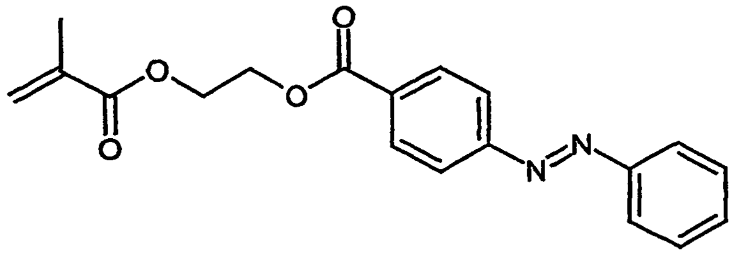

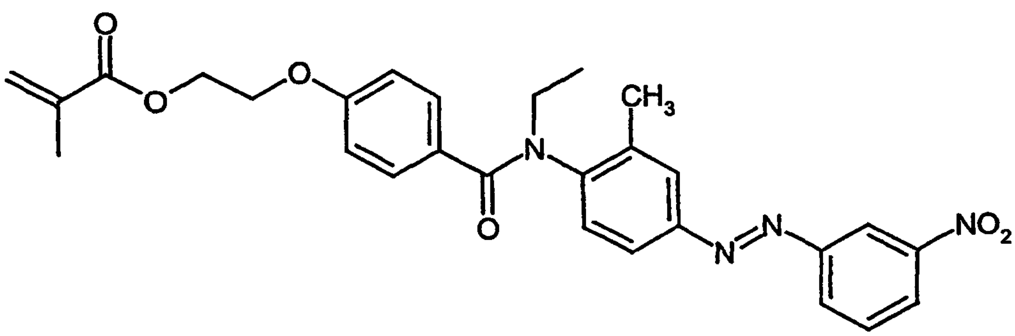

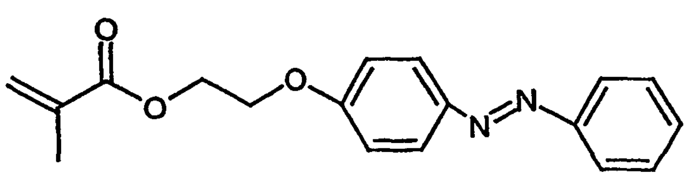

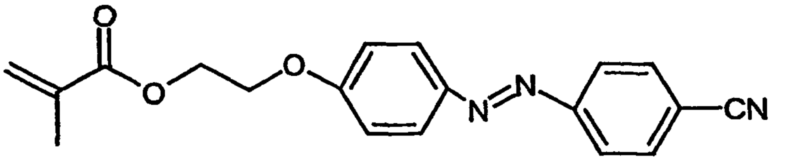

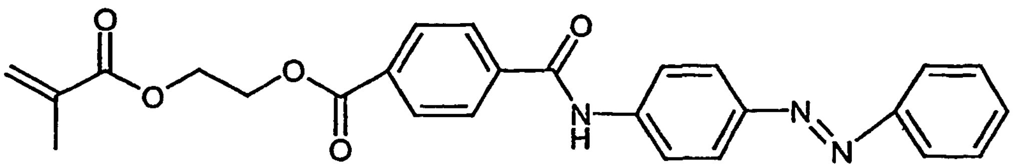

**12.** Misch-Polymer nach einem oder mehreren der Ansprüche 1 bis 11, **dadurch gekennzeichnet, dass** die polarisierbaren aromatischen Gruppen M der Formel (CVI)

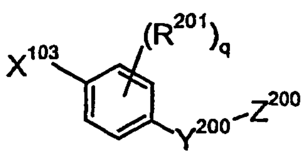

(CVI)

entsprechen,
worin

$Z^{200}$ für einen Rest der Formeln

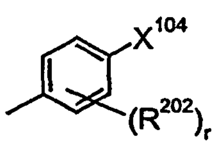

(CVIa)

oder

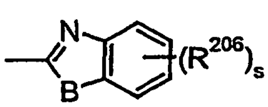

(CVIb)

steht,

worin

B für O, S oder N-$C_1$- bis $C_4$-Alkyl steht,

$X^{103}$ für $-X^{103'}-(Q^{102})_j-T^{102}-S^{102}-$ steht,

$X^{104}$ für $X^{104'}-R^{203}$ steht,

$X^{103'}$ und $X^{104'}$ unabhängig voneinander für eine direkte Bindung, -O-, -S-, $-(N-R^{205})-$, $-C(R^{206}R^{207})-$, -(C=O)-, -(CO-O)-, $-(CO-NR^{205})-$, $-(SO_2)-$, $-(SO_2-O)-$, $-(SO_2-NR^{205})-$, $-(C=NR^{208})-$ oder $-(CNR^{208}-NR^{205})-$ stehen,

$R^{205}$, $R^{208}$ und $R^{203}$ unabhängig voneinander für Wasserstoff, $C_1$- bis $C_{20}$-Alkyl, $C_3$- bis $C_{10}$-Cycloalkyl, $C_2$- bis $C_{20}$-Alkenyl, $C_6$- bis $C_{10}$-Aryl, $C_1$- bis $C_{20}$-Alkyl-(C=O)-, $C_3$- bis $C_{10}$-Cycloalkyl-(C=O)-, $C_2$- bis $C_{20}$-Alkenyl-(C=O)-, $C_6$- bis $C_{10}$-Aryl-(C=O)-, $C_1$- bis $C_{20}$-Alkyl-$(SO_2)$-, $C_3$- bis $C_{10}$-Cycloalkyl-$(SO_2)$-, $C_2$- bis $C_{20}$-Alkenyl-$(SO_2)$- oder $C_6$-bis $C_{10}$-Aryl-$(SO_2)$- stehen oder

$X^{104'}-R^{203}$ für Wasserstoff, Halogen, Cyan, Nitro, $CF_3$ oder $CCl_3$ stehen kann,

$R^{206}$ und $R^{207}$ unabhängig voneinander für Wasserstoff, Halogen, $C_1$- bis $C_{20}$-Alkyl, $C_1$- bis $C_{20}$-Alkoxy, $C_3$- bis $C_{10}$-Cycloalkyl, $C_2$- bis $C_{20}$-Alkenyl oder $C_6$- bis $C_{10}$-Aryl stehen,

$Y^{200}$ für eine einfache Bindung, -COO-, OCO-, -CONH-, -NHCO-, $-CON(CH_3)-$, $-N(CH_3)CO-$, -O-, NH- oder $-N(CH_3)-$ steht,

$R^{201}$, $R^{202}$, $R^{206}$ unabhängig voneinander für Wasserstoff, Halogen, Cyano, Nitro, $C_1$- bis $C_{20}$-Alkyl, $C_1$- bis $C_{20}$-Alkoxy, Phenoxy, $C_3$- bis $C_{10}$-Cycloalkyl, $C_2$- bis $C_{20}$-Alkenyl oder $C_6$- bis $C_{10}$-Aryl, $C_1$- bis $C_{20}$-Alkyl-(C=O)-, $C_6$- bis $C_{10}$-Aryl-(C=O)-, $C_1$- bis $C_{20}$-Alkyl-$(SO_2)$-, $C_1$-bis $C_{20}$-Alkyl-(C=O)-O-, $C_1$- bis $C_{20}$-Alkyl-(C=O)-NH-, $C_6$- bis $C_{10}$-Aryl-(C=O)-NH-, $C_1$- bis $C_{20}$-Alkyl-O-(C=O)-, $C_1$- bis $C_{20}$-Alkyl-NH-(C=O)- oder $C_6$- bis $C_{10}$-Aryl-NH-(C=O)- stehen,

q, r und s unabhängig voneinander für eine ganze Zahl von 0 bis 4, vorzugsweise 0 bis 2 stehen,

$Q^{102}$ für -O-, -S-, $-(N-R^{205})-$, $-C(R^{206}R^{207})-$, -(C=O)-, -(CO-O)-, $-(CO-NR^{205})-$, $-(SO_2)-$, $-(SO_2-O)-$, $-(SO_2-NR^{205})-$, $-(C=NR^{208})-$, $-(CNR^{208}-NR^{205})-$, $-(CH_2)_p-$, p- oder m-$C_6H_4$- oder einen zweibindigen Rest der Formeln

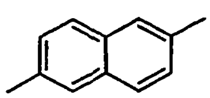 oder 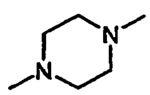

steht,

j für eine ganze Zahl von 0 bis 4 steht, wobei für j > 1 die einzelnen $Q^{102}$ verschiedene Bedeutungen haben können,

$T^{102}$ für $-(CH_2)_p-$ steht, wobei die Kette durch -O-, $-NR^{209}-$, oder $-OSiR^{220}{}_2O-$ unterbrochen sein kann,

$S^{102}$ für eine direkte Bindung, -O-, -S- oder $-NR^{209}-$ steht,

p für eine ganze Zahl von 2 bis 12, vorzugsweise 2 bis 8, insbesondere 2 bis 4 steht,

$R^{209}$ für Wasserstoff, Methyl, Ethyl oder Propyl steht und

$R^{220}$ für Methyl oder Ethyl steht.

**13.** Misch-Polymer nach einem oder mehreren der Ansprüche 1 bis 12, **dadurch gekennzeichnet, dass** die Monomere, die eine formanisotrope Gruppierungen M haben, die Formel (CVII)

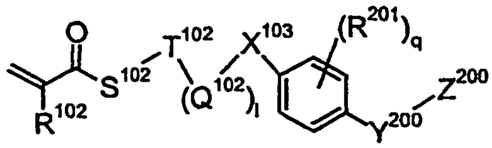

(CVII)

besitzen,
worin

R^102 für Wasserstoff oder Methyl steht und

die anderen Reste die oben angegebene Bedeutung besitzen.

**14.** Mischpolymer nach Anspruch 13, wobei Monomere, die formanisotrope Gruppen (M) tragen, ausgewählt sind aus den Strukturen

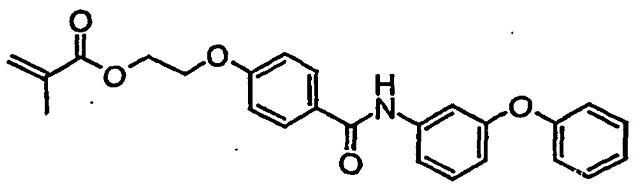

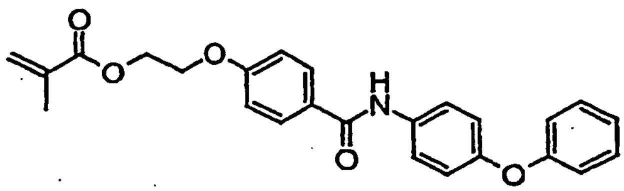

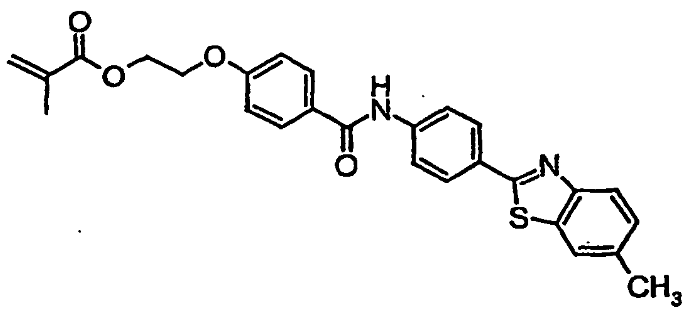

**15.** Mischpolymer nach einem oder mehreren der Ansprüche 1 bis 14, **dadurch gekennzeichnet, dass** die Monomeren der Formel (CV) und der Formel (CVII) im Verhältnis 1:1 bis 1:30 eingesetzt werden.

**16.** Misch-Polymer nach einem oder meheren der Ansprüche 1 bis 15, **dadurch gekennzeichnet, dass** es eine optische Dichte ≤ 2 aufweist.

**17.** Verfahren zur Herstellung der Misch-Polymere gemäß einem oder mehreren der Anspruche 1 bis 16, wobei die Polymeren (A) und (B) durch radikalische Polymerisation hergestellt werden und die Mischpolymere durch Mischen dieser Einzelpolymeren in den gewünschten Mengenverhältnissen unter Erwärmen über die Glastemperatur hergestellt werden.

**18.** Verwendung der Misch-Polymere gemäß einem oder mehreren der Ansprüche 1 bis 16 zur Herstellung von optischen Elementen und Speicherelementen, bevorzugt Volumenspeicher.

**19.** Verwendung der Misch-Polymeren gemäß Anspruch 18, **dadurch gekennzeichnet, dass** das optische Element zu Speicherung von Daten eingesetzt wird.

**20.** Verwendung der Mischpolymeren gemäß einem oder mehreren der Ansprüche 18 bis 19, **dadurch gekennzeichnet, dass** das optische Element oder Speicherelement, bevorzugt Volumenspeicher zur Speicherung von Daten durch Holographie eingesetzt wird.

**21.** Verwendung der Mischpolymeren gemäß einem oder mehreren der Ansprüche 18 bis 20, **dadurch gekennzeichnet, dass** mittels eines Laserstrahls Information in das optische Element und/oder Speicher eingeschrieben wird.

**22.** Speicher, bevorzugt Volumenspeicher, enthaltend mindestens ein Misch-Polymer gemäß einem oder mehrerer der Ansprüche 1 bis 16, wobei dieser eine durchstrahlte Dicke von ≥ 0,1 mm aufweist.

**23.** Verfahren zur Herstellung von optischen Elementen und Speicherelementen, bevorzugt Volumenspeicher durch Spritzguss gemäß einem oder mehrerer der vorangegangenen Ansprüche.

**24.** Verfahren gemäß Anspruch 23, wobei zusätzlich der Formkörper poliert wird.

**25.** Verfahren gemäß Anspruch 23 und/oder 24, wobei zusätzlich eine transparente Schutzschicht aufgebracht wird.

**26.** Optische Elemente und Speicher gemäß einem oder mehrerer der Ansprüche 23 bis 25.

## Claims

**1.** A mixed polymer, **characterised in that** it consists of
at least one polymer (A) having at least 10 repeat units with the general formula (CI)

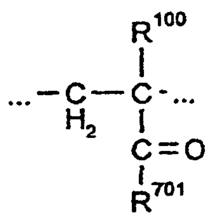

(CI),

where

$R^{100}$ represents hydrogen or methyl and

$R^{701}$ represents -O-$R^{801}$, where

$R^{801}$ stands for hydrogen or $C_1$-$C_8$ linear or branched-chain alkyl without photoisomerisable groups, preferably methyl, ethyl, propyl, n-butyl, particularly preferably methyl, and

at least one polymer (B) having at least 3 repeat units with the general formula (CII)

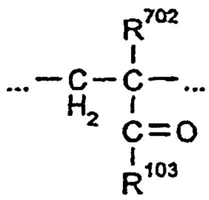

(CII)

where

$R^{702}$ represents hydrogen or methyl and

$R^{103}$ for [-S-T-Q-P] and where P represents A and/or M,

where, however, a polymer (B) is always contained in which P represents A,
where the side-chains branching off from the main chain, of the formula S-T-Q-P with P = A (dye group), M (mesogen), are governed by the following definitions:

$$S\text{-}T\text{-}Q\text{-}P = S^1 - T^1 - Q^1 - A$$

$$S\text{-}T\text{-}Q\text{-}P = S^2 - T^2 - Q^2 - M$$

where

$S^1$, $S^2$ signify independently of one another the atoms O, S or the group $NR^1$,

$R^1$ signifies hydrogen or $C_1$-$C_4$ alkyl,

$T^1$, $T^2$ signify independently of one another the group $(CH_2)_n$, which may optionally be interrupted by -O-, $-NR^1$- or $-OSiR^1{}_2O$- and/or substituted by methyl or ethyl,

n signifies the numbers 2, 3 or 4,

$Q^1$, $Q^2$ a divalent group,

A a unit which may absorb electromagnetic radiation and

M a polerisable aromatic group having at least 12 $\pi$-electrons.

2. A mixed polymer according to claim 1, **characterised in that** at least 10 repeat units are contained in the polymer (A).

3. A mixed polymer according to claim 1 and/or 2, **characterised in that** at least 3 repeat units are contained in the polymer (B).

4. A mixed polymer according to one or more of claims 1 to 3, **characterised in that** more than one polymer (A) and/or polymer (B) is contained, wherein however a polymer (B) is always contained in which P represents A.

5. A mixed polymer according to one or more of claims 1 to 4, **characterised in that** the ratio of the sum of the monomers of the polymer (B) to the sum of the monomers of the polymer (A) lies between 1 : 1 and 1 : 10 000.

6. A mixed polymer according to one or more of claims 1 to 5, **characterised in that** polymer (A) contains methyl methacrylate units.

7. A mixed polymer according to one or more of claims 1 to 6, **characterised in that** polymer (B) contains at least

two different monomers with the general formula [-S-T-Q-P], wherein at least one of said monomers bears a photoisomerisable group (A).

**8.** A mixed polymer according to one or more of claims 1 to 7, **characterised in that** polymer (B) contains a monomer in which the photoisomerisable group (A) is an azo group.

**9.** A mixed polymer according to one or more of claims 1 to 8, **characterised in that** the photoisomerisable group (A) has the structure (CIV)

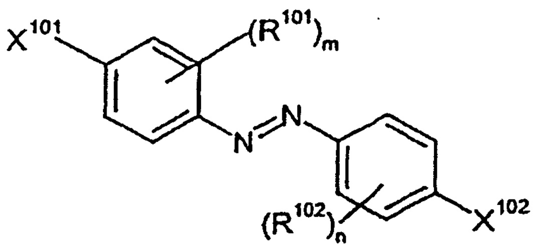

(CIV)

where

| | |
|---|---|
| $R^{101}$ and $R^{102}$ | represent independently of one another hydrogen or a nonionic substituent, |
| m and n | represent independently of one another a whole number from 0 to 4, preferably 0 to 2, |
| $X^{101}$ | represents the linkage with $S^{101}T^{101}Q^{101}$, i.e. $X^{101}$ has the meaning $X^{101'}$, where $X^{101'}$ is linked to the Q with the 2nd valency, |
| $X^{102}$ | signifies $X^{102'}$-$R^{104}$, |
| $X^{101'}$ and $X^{102'}$ | represent a direct bond, -O-, -S-, -(N-$R^{105}$)-, -C($R^{106}R^{107}$)-, -(C=O), -(CO-O)-, -(CO-N$R^{105}$)-, -($SO_2$)-, -($SO_2$-O)-, -($SO_2$-N$R^{105}$)-, -(C=N$R^{18}$)- or -(CN$R^{18}$-N$R^{15}$)-, |
| $R^{104}$, $R^{15}$ and $R^{18}$ | represent independently of one another hydrogen, $C_1$- to $C_{20}$-alkyl, $C_3$- to $C_{10}$-cycloalkyl, $C_2$- to $C_{20}$-alkenyl, $C_6$- to $C_{10}$-aryl, $C_1$- to $C_{20}$-alkyl-(C=O)-, $C_3$- to $C_{10}$-cycloalkyl-(C=O)-, $C_2$- to $C_{20}$-alkenyl-(C=O)-, $C_6$- to $C_{10}$-aryl-(C=O)-, $C_1$- to $C_{20}$-alkyl-($SO_2$)-, $C_3$- to $C_{10}$-cycloalkyl-($SO_2$)-, $C_2$-to $C_{20}$-alkenyl-($SO_2$)- or $C_6$- to $C_{10}$-aryl-($SO_2$)- or |
| $X^{102'}$-$R^{104}$ | may represent hydrogen, halogen, cyano, nitro, $CF_3$ or $CCl_3$, |
| $R^{106}$ and $R^{107}$ | represent independently of one another hydrogen, halogen, $C_1$- to $C_{20}$- alkyl, $C_1$- to $C_{20}$-alkoxy, $C_3$- to $C_{10}$-cycloalkyl, $C_2$- to $C_{20}$-alkenyl or $C_6$- to $C_{10}$-aryl, |
| $S^{101}$ | signifies the atoms O, S or the group N$R^{109}$, |
| $R^{109}$ | signifies hydrogen or $C_1$-$C_4$-alkyl, |
| $T^{101}$ | signifies the group $(CH_2)_x$, which may optionally be interrupted by -O-, -N$R^{109}$- or -OSi$R^{109}{}_2$O- and/or substituted by methyl or ethyl, |
| x | signifies the numbers 2, 3 or 4, |
| $Q^{101}$ | signifies $Z^{101}$, $Z^{102}$ or the group -$Z^{101}$-$X^{100}$-$Z^{102}$-, where |
| $Z^{101}$ and $Z^{102}$ | signify independently of one another the groups -S-, -$SO_2$-, -O-, -COO-, -OCO-, -CON$R^{109}$-, -N$R^{109}$CO-, -N$R^{109}$-, -N=N- , -CH=CH- , -N=CH-, -CH=N- or the group -$(CH_2)_y$- with y = 1 or 2 and |

$X^{100}$ signifies a 5- or 6-member cycloaliphatic, aromatic or heterocyclic ring, for the case $Z^{101}$ = -COO- or -CONR$^{109}$- a direct bond or the group -(CH=CH)$_y$-,

where y has the meaning given above.

**10.** A mixed polymer according to one or more of claims 1 to 9, **characterised in that** the monomers which bear a photoisomerisable group possess the formula (CV)

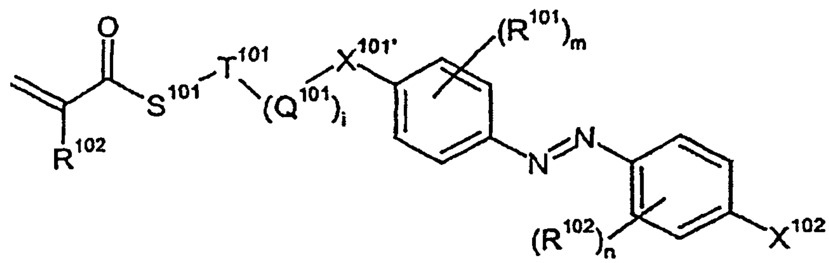

(CV),

where

$R^{102}$ represents hydrogen or methyl and

the other groups have the meaning given above.

**11.** A mixed polymer according to claim 10, wherein the monomers which bear photoisomerisable groups are selected from the structures

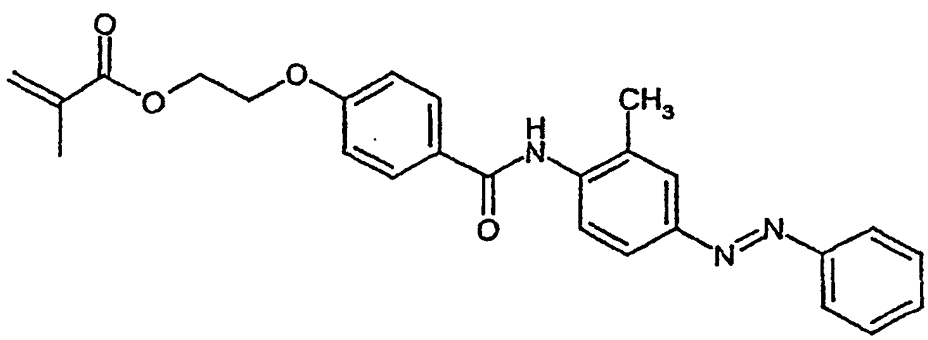

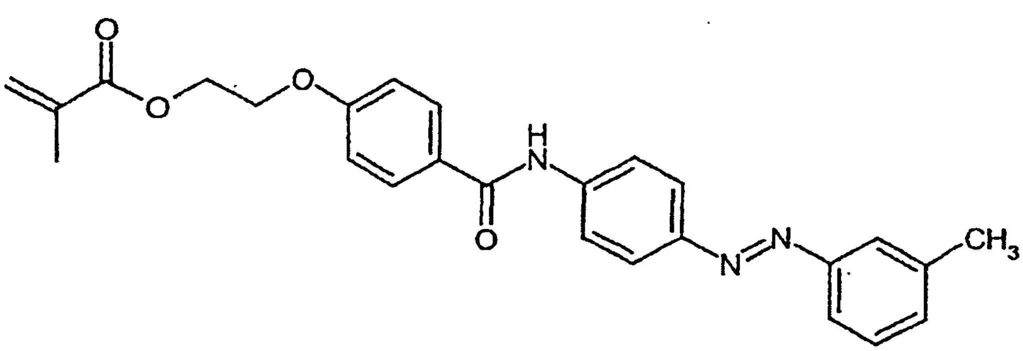

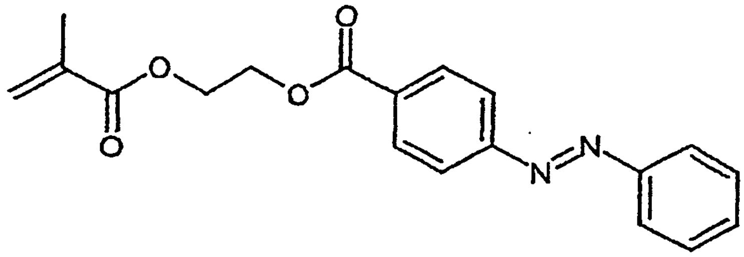

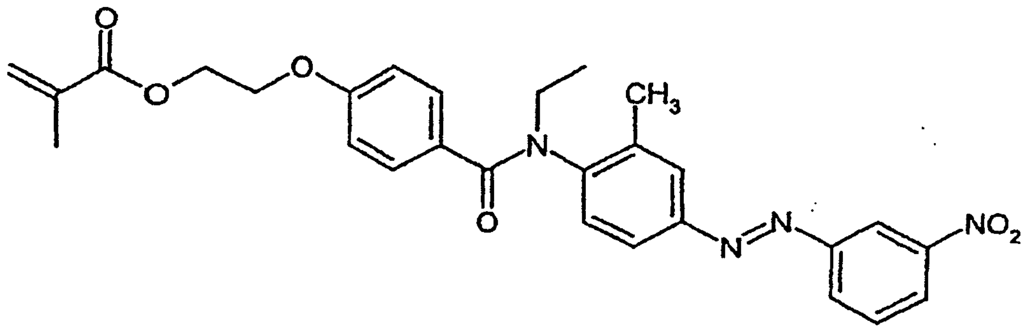

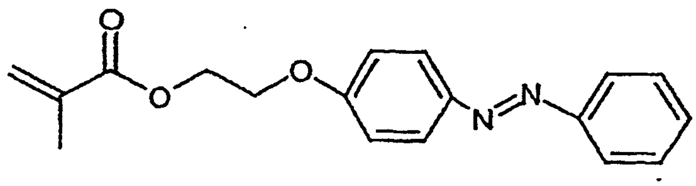

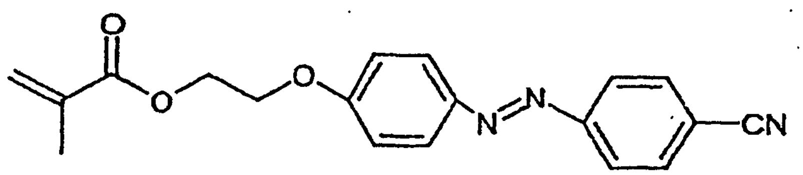

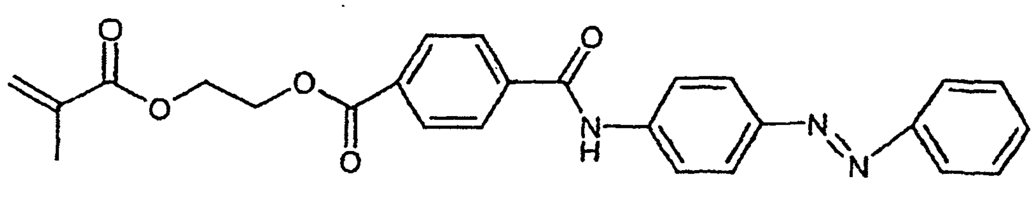

12. A mixed polymer according to one or more of claims 1 to 11, **characterised in that** the polarisable aromatic groups M correspond to the formula (CVI)

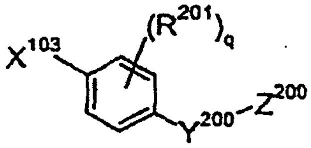

(CVI)

where

$Z^{200}$ represents a group with the formulae

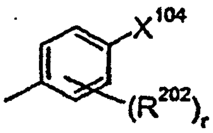

(CVIa)

or

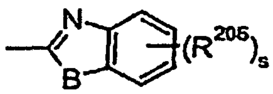

(CVIb),

where

| | |
|---|---|
| B | represents O, S or N-$C_1$- to $C_4$-alkyl, |
| $X^{103}$ | represents -$X^{103'}$-$(Q^{102})_j$-$T^{102}$-$S^{102}$-, |
| $X^{104}$ | represents $X^{104'}$-$R^{203}$, |
| $X^{103'}$ and $X^{104'}$ | represent independently of one another a direct bond, -O-, -S-, -(N-$R^{205}$)-, -C($R^{206}R^{207}$)-, -(C=O)-, -(CO-O)-, -(CO-N$R^{205}$)-, -($SO_2$)-, - ($SO_2$-O)-, -($SO_2$-N$R^{205}$)-, -(C=N$R^{208}$)- or -(CN$R^{208}$-N$R^{205}$), |
| $R^{205}$, $R^{208}$ and $R^{203}$ | represent independently of one another hydrogen, $C_1$- to $C_{20}$-alkyl, $C_3$- to $C_{10}$-cycloalkyl, $C_2$- to $C_{20}$-alkenyl, $C_6$- to $C_{10}$-aryl, $C_1$- to C20-alkyl-(C=O)-, $C_3$- to $C_{10}$-cycloalkyl-(C=O)-, $C_2$- to $C_{20}$-alkenyl- (C=O) -, $C_6$- to $C_{10}$-aryl- (C=O) -, $C_1$- to $C_{20}$-alkyl- ($SO_2$)-, $C_3$- to $C_{10}$-cycloalkyl- ($SO_2$)-, $C_2$- to $C_{20}$-alkenyl- ($SO_2$)- or $C_6$- to $C_{10}$-aryl- ($SO_2$)- or |
| $X^{104'}$-$R^{203}$ | may represent hydrogen, halogen, cyano, nitro, $CF_3$ or $CCl_3$, |
| $R^{206}$ and $R^{207}$ | represent independently of one another hydrogen, halogen, $C_1$- to $C_{20}$-alkyl, $C_1$- to $C_{20}$-alkoxy, $C_3$- to $C_{10}$-cycloalkyl, $C_2$- to $C_{20}$-alkenyl or $C_6$- to $C_{10}$-aryl, |
| $Y^{200}$ | represents a single bond, -COO-, OCO-, -CONH-, -NHCO-, -CON($CH_3$)-, -N($CH_3$)CO-, -O-, -NH- or -N($CH_3$)-, |
| $R^{201}$, $R^{202}$, $R^{206}$ | represent independently of one another hydrogen, halogen, cyano, nitro, $C_1$- to $C_{20}$-alkyl, $C_1$- to $C_{20}$-alkoxy, phenoxy, $C_3$- to $C_{10}$-cycloalkyl, $C_2$- to $C_{20}$-alkenyl or $C_6$- to $C_{10}$-aryl, $C_1$- to $C_{20}$-alkyl-(C=O)-, $C_6$- to $C_{10}$-aryl-(C=O)-, $C_1$- to $C_{20}$-alkyl-($SO_2$)-, $C_1$- to $C_{20}$-alkyl- (C=O) -O-, $C_1$- to $C_{20}$-alkyl-(C=O) -NH-, $C_6$- to $C_{10}$-aryl-(C=O)-NH-, $C_1$- to $C_{20}$-alkyl-O-(C=O)-, $C_1$- to $C_{20}$-alkyl-NH-(C=O)- or $C_6$- to $C_{10}$-aryl-NH-(C=O)-, |

q, r and s represent independently of one another a whole number from 0 to 4, preferably 0 to 2,

$Q^{102}$ represents a -O-, -S-, -(N-$R^{205}$)-, -C($R^{206}R^{207}$)-, -(C=O)-, -(CO-O)-, -(CO-N$R^{205}$)-, -($SO_2$)-, -($SO_2$-O)-, -($SO_2$-N$R^{205}$)-, (C=N$R^{208}$)-, -(CN$R^{208}$-N$R^{205}$)-, -$(CH_2)_p$-, p- or m-$C_6H_4$- or a divalent group with the formulae

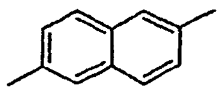

or

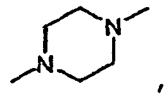

,

j represents a whole number from 0 to 4, where for j > 1 the individual $Q^{102}$ may have different meanings,

$T^{102}$ represents -$(CH_2)_p$-, where the chain may be interrupted by -O-, -N$R^{209}$- or -OSi$R^{220}_2$O-,

$S^{102}$ represents a direct bond, -O-, -S- or -N$R^{209}$-,

p represents a whole number from 2 to 12, preferably 2 to 8, in particular 2 to 4,

$R^{209}$ represents hydrogen, methyl, ethyl or propyl and

$R^{220}$ represents methyl or ethyl.

13. A mixed polymer according to one or more of claims 1 to 12, **characterised in that** the monomers which have a grouping M exhibiting form anisotropy possess the formula (CVII)

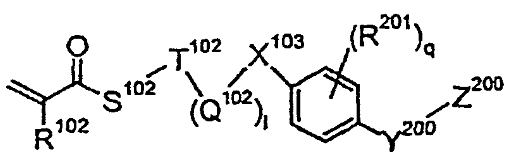

(CVII)

where

$R^{102}$ represents hydrogen or methyl and

the other groups possess the meanings given above.

14. A mixed polymer according to claim 13, wherein monomers which bear the groups exhibiting form anisitropy (M) are selected from the structures

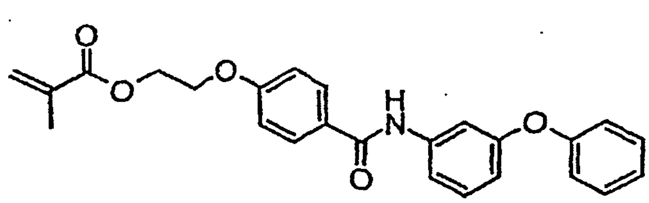

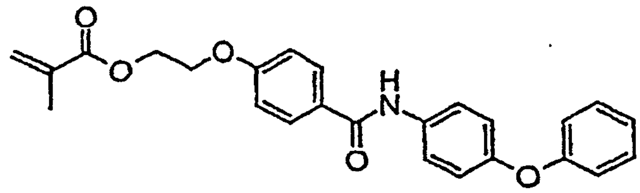

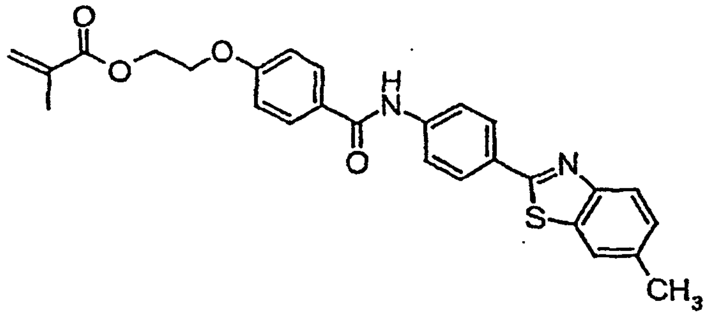

**15.** Mixed polymer according to one or more of claims 1 to 14, **characterised in that** the monomers of formula (CV) and of formula (CVII) are used in the ratio 1 : 1 to 1 : 30.

**16.** Mixed polymer according to one or more of claims 1 to 15, **characterised in that** it has an optical density ≤ 2.

**17.** A method for producing the mixed polymers according to one or more of claims 1 to 16, wherein the polymers (A) and (B) are produced by radical polymerisation and the mixed polymers are produced by mixing of said individual polymers in the desired quantitative ratios with heating to above the glass transition temperature.

**18.** Use of the mixed polymers according to one or more of claims 1 to 16 for producing optical elements and storage elements, preferably high-volume stores.

**19.** Use of the mixed polymers according to claim 18, **characterised in that** the optical element is used for the storage of data.

**20.** Use of the mixed polymers according to one or more of claims 18 to 19, **characterised in that** the optical element or storage element, preferably high-volume store, is used for the storage of data by holography.

**21.** Use of the mixed polymers according to one or more of claims 18 to 20, **characterised in that** information is inscribed into the optical element and/or store by means of a laser beam.

**22.** Store, preferably high-volume store, containing at least one mixed polymer according to one or more of claims 1 to 16, wherein the latter has a transilluminated thickness of ≥ 0.1 mm.

**23.** Method for producing optical elements and storage elements, preferably high-volume stores, by injection moulding according to one or more of the preceding claims.

**24.** Method according to claim 23, wherein in addition the moulding is polished.

**25.** Method according to claim 23 and/or 24, wherein in addition a transparent protective layer is applied.

**26.** Optical elements and stores according to one or more of claims 23 to 25.

## Revendications

**1.** Polymère mélangé **caractérisé en ce qu'**il consiste en

au moins un polymère (A) à au moins 10 motifs répétés de formule générale (CI)

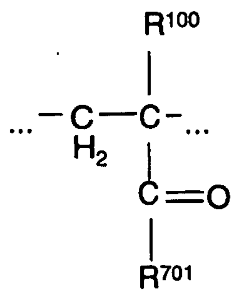

(CI),

dans laquelle

$R^{100}$ représente l'hydrogène ou un groupe méthyle,
$R^{701}$ représente -Q-$R^{801}$, et
$R^{801}$ représente l'hydrogène ou un radical alkyle à chaîne droite ou ramifiée en $C_1$-$C_8$ sans groupe photo-isomérisable, de préférence un radical méthyle, éthyle, propyle, n-butyle, et spécialement un radical méthyle, et

au moins un polymère (B) à au moins trois motifs répétés de formule générale (CII)

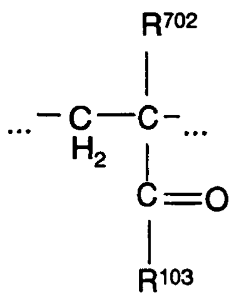

(CII)

dans laquelle

$R^{702}$ représente l'hydrogène ou un groupe méthyle et
$R^{103}$ représente [-S-T-Q-P], P représentant A et/ou M,

avec dans tous les cas un polymère (B) pour lequel P = A, les définitions générales suivantes s'appliquant à la chaîne latérale partant de la chaîne principale et répondant à la formule S-T-Q-P avec P = A (groupe colorant), M (mésogène) :

$$S\text{-}T\text{-}Q\text{-}P = S^1\text{-}T^1\text{-}Q^1\text{-}A$$

$$S\text{-}T\text{-}Q\text{-}P = S^2\text{-}T^2\text{-}Q^2\text{-}M$$

dans lesquelles

$S^1$,$S^2$ représentant chacun, indépendamment l'un de l'autre, un atome O, S ou un groupe $NR^1$,
$R^1$ représente l'hydrogène ou un groupe alkyle en $C_1$-$C_4$,

| | |
|---|---|
| $T^1$, $T^2$ | représentent chacun, indépendamment l'un de l'autre, le groupe $(CH_2)_n$, éventuellement interrompu par -O-, $-NR^1-$ ou $-OSiR^1{}_2O-$ et/ou substitué par des groupes méthyle ou éthyle, |
| n | est égal à 2, 3 ou 4, |
| $Q^1$, $Q^2$ | représentent chacun un radical divalent, |
| A | représente un motif capable d'absorber le rayonnement électromagnétique et |
| M | représente un groupe aromatique polarisable à au moins 12 électrons $\pi$. |

**2.** Polymère mélangé selon la revendication 1, **caractérisé en ce que** le polymère (A) contient au moins 10 motifs répétés.

**3.** Polymère mélangé selon la revendication 1 ou 2, **caractérisé en ce que** le polymère (B) contient au moins 3 motifs répétés.

**4.** Polymère mélangé selon une ou plusieurs des revendications 1 à 3, **caractérisé en ce qu'**il contient plus d'un polymère (A) et/ou (B), avec cependant dans tous les cas un polymère (B) pour lequel P = A.

**5.** Polymère mélangé selon une ou plusieurs des revendications 1 à 4, **caractérisé en ce que** le rapport entre la somme des monomères du polymère (B) à la somme des monomères du polymère (A) va de 1:1 à 1:10 000.

**6.** Polymère mélangé selon une ou plusieurs des revendications 1 à 5, **caractérisé en ce que** le polymère (A) contient des motifs de méthacrylate de méthyle.

**7.** Polymère mélangé selon une ou plusieurs des revendications 1 à 6, **caractérisé en ce que** le polymère (B) contient au moins deux monomères différents de formule générale [-S-T-Q-P], l'un au moins de ces monomères portant un groupe photo-isomérisable A.

**8.** Polymère mélangé selon une ou plusieurs des revendications 1 à 7, **caractérisé en ce que** le polymère (B) contient un monomère dans lequel le groupe photo-isomérisable A est un groupe azo.

**9.** Polymère mélangé selon une ou plusieurs des revendications 1 à 8, **caractérisé en ce que** le groupe photo-isomérisable A possède la structure (CIV)

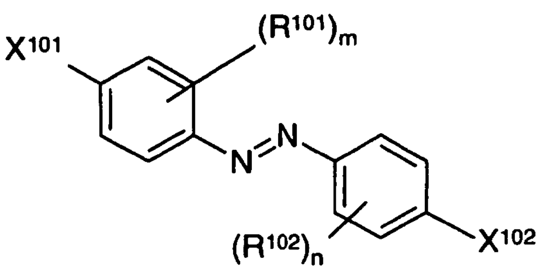

(CIV)

dans laquelle

| | |
|---|---|
| $R^{101}$ et $R^{102}$ | représentent chacun, indépendamment l'un de l'autre l'hydrogène ou un substituant non ionique, |
| m et n | sont égaux chacun, indépendamment l'un de l'autre, à un nombre entier allant de 0 à 4 et de préférence de 0 à 2, |
| $X^{101}$ | représente la liaison vers $S^{101}T^{101}Q^{101}$, c'est-à-dire que $X^{101}$ représente $X^{101'}$, $X^{101'}$ étant relié à la deuxième valence de Q, |
| $X^{102}$ | représente $X^{102'}-R^{104}$, |
| $X^{101'}$ et $X^{102'}$ | représentent chacun une liaison directe, -O-, -S-, $-(N-R^{105})-$, $-C(R^{106}R^{107})-$, -(C=O)-, -(CO-O)-, $-(CO-NR^{105})-$, $-(SO_2)-$, $-(SO_2-O)-$, $-(SO_2-NR^{105})-$, $-(C=NR^{18})-$ ou $-(CNR^{18}-NR^{15})-$, |
| $R^{104}$, $R^{15}$ et $R^{18}$ | représentent chacun, indépendamment les uns des autres, l'hydrogène, un groupe alkyle en $C_1$-$C_{20}$, cycloalkyle en $C_3$-$C_{10}$, alcényle en $C_2$-$C_{20}$, aryle en $C_6$-$C_{10}$, (alkyle en $C_1$-$C_{20}$)-C=O-, (cycloalkyle en $C_3$-$C_{10}$)-C=O-, (alcényle en $C_2$-$C_{20}$)-C=O-, (aryle en $C_6$-$C_{20}$)-C=O-, (alkyle en $C_1$-$C_{20}$)-$SO_2$-, (cycloalkyle en $C_3$-$C_{10}$)-$SO_2$-, (alcényle en $C_2$-$C_{20}$)-$SO_2$- ou (aryle en $C_6$-$C_{10}$) |

| | |
|---|---|
| | $-SO_2-$ ou bien |
| $X^{102'}-R^{104}$ | représente l'hydrogène, un halogène, un groupe cyano, nitro, $CF_3$ OU $CCl_3$, |
| $R^{106}$ et $R^{107}$ | représentent chacun, indépendamment l'un de l'autre, l'hydrogène, un halogène, un groupe alkyle en $C_1$-$C_{20}$, alcoxy en $C_1$-$C_{20}$, cycloalkyle en $C_3$-$C_{10}$, alcényle en $C_2$-$C_{20}$ ou aryle en $C_6$-$C_{10}$, |
| $S^{101}$ | représente un atome O, S ou le groupe $NR^{109}$, |
| $R^{109}$ | représente l'hydrogène ou un groupe alkyle en $C_1$-$C_4$, |
| $T^{101}$ | représente le groupe $(CH_2)_x$ éventuellement interrompu par -O-, $-NR^{109}-$ ou $-OSiR^{109}{}_2O-$ et/ou substitué par des groupes méthyle ou éthyle, |
| X | est égal à 2, 3 ou 4, |
| $Q^{101}$ | représente $Z^{101}$, $Z^{102}$ ou le groupe $-Z^{101}-X^{100}-Z^{102}-$ dans lequel |
| $Z^{101}$ et $Z^{102}$ | représentent chacun, indépendamment l'un de l'autre, -S-, $-SO_2-$, -O-, -COO-, -OCO-, $-CONR^{109}-$ $-NR^{109}CO-$, $-NR^{109}-$, -N=N-, -CH=CH-, -N=CH-, -CH=N- ou le groupe $-(CH_2)_y-$ avec y = 1 ou 2 et |
| $X^{100}$ | représente un noyau cycloaliphatique, aromatique ou hétérocyclique à 5 ou 6 chaînons ou bien lorsque $Z^{101}$ = -COO- ou $-CONR^{109}-$, une liaison directe ou le groupe -(CH=CH)y-, y ayant les significations indiquées ci-dessus. |

**10.** Polymère mélangé selon une ou plusieurs des revendications 1 à 9, **caractérisé en ce que** les monomères portant un groupe photo-isomérisable répondent à la formule (CV)

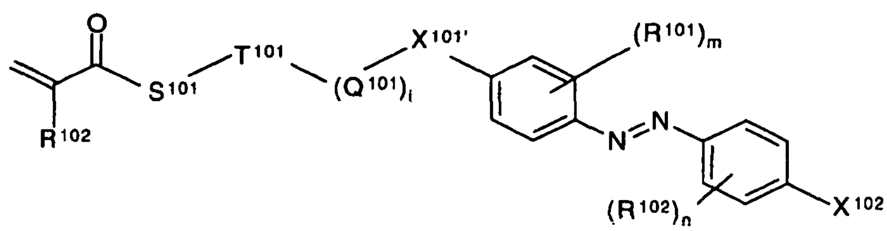

(CV)

dans laquelle

$R^{102}$ représente l'hydrogène ou un groupe méthyle et

les autres symboles ont les significations indiquées ci-dessus.

**11.** Polymères mélangés selon la revendication 10, dont les monomères portant des groupes photo-isomérisables sont choisis parmi ceux possédant les structures suivantes :

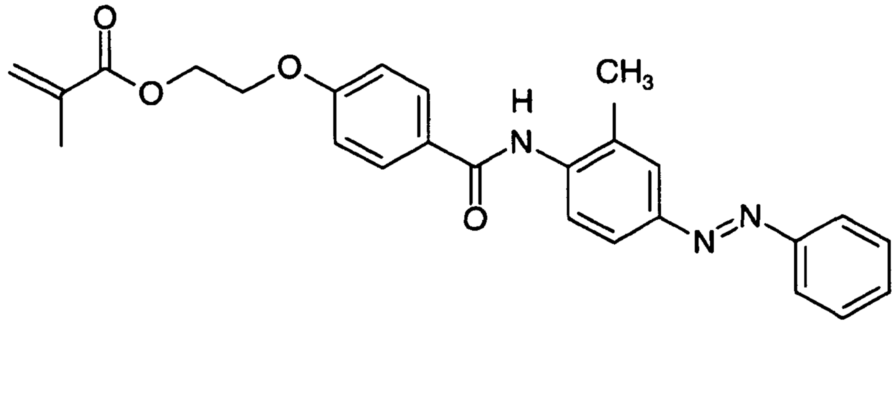

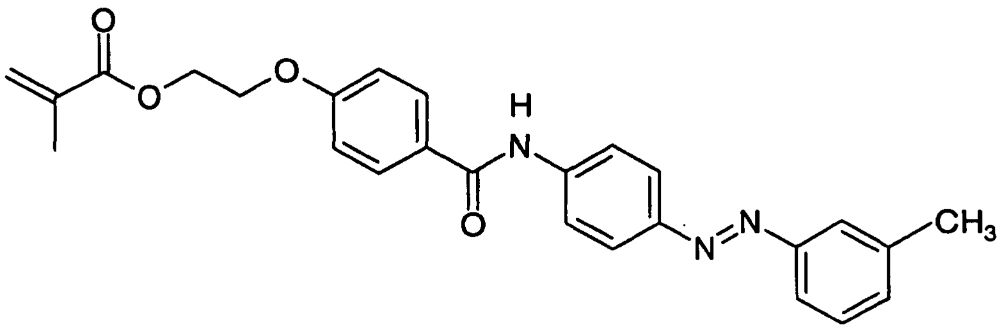

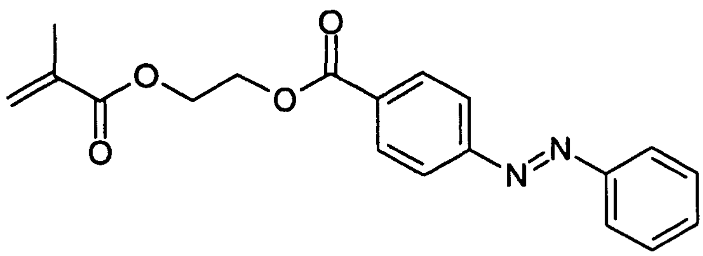

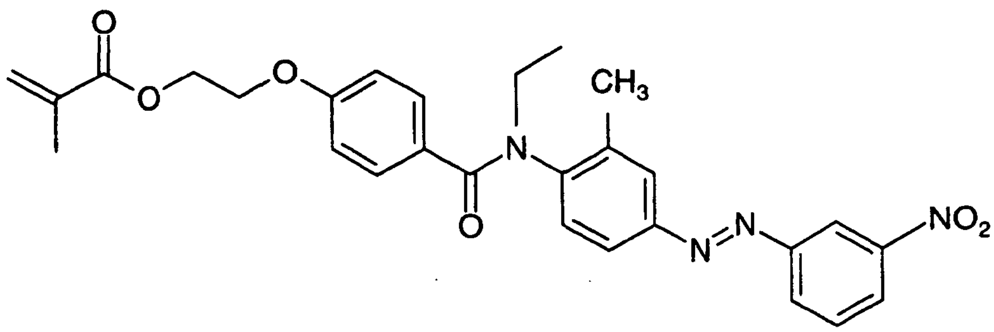

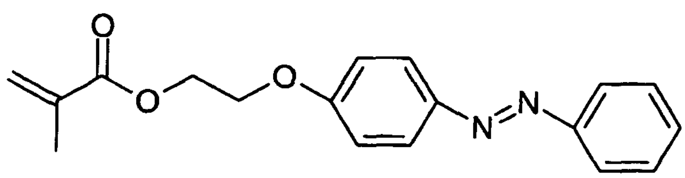

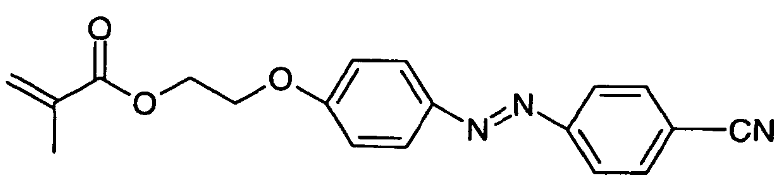

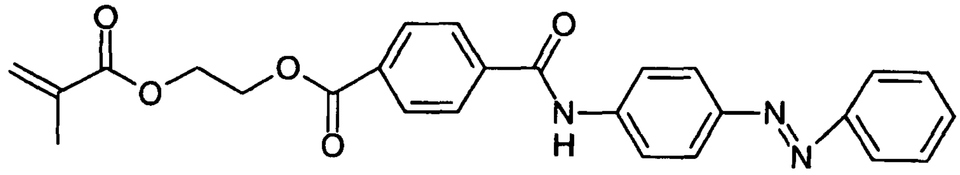

**12.** Polymère mélangé selon une ou plusieurs des revendications 1 à 11, **caractérisé en ce que** les groupes aromatiques polarisables M répondent à la formule (CVI)

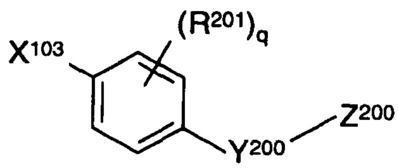

(CVI)

dans laquelle

$Z^{200}$ représente un groupe de formule

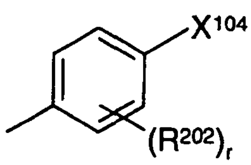

(CVIa)

ou

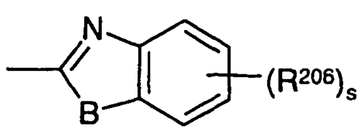

(CVIb)

dans lesquelles

| | |
|---|---|
| B | représente O, S ou N-alkyle en $C_1$-$C_4$, |
| $X^{103}$ | représente $-X^{103'}-(Q^{102})_j-T^{102}-S^{102}-$, |
| $X^{104}$ | représente $X^{104'}-R^{203'}$ |
| $X^{103'}$ et $X^{104'}$ | représentent chacun, indépendamment l'un de l'autre, une liaison directe, -O-, -S-, $-(N-R^{205})-$, $-C(R^{206}R^{207})-$, -(C=O)-, -(CO-O)-, $-(CO-NR^{205})-$, $-(SO_2)-$, $-(SO_2-O)-$, $-(SO_2-NR^{205})-$, $-(C=NR^{208})-$ ou $-(CNR^{208}-NR^{205})-$, |
| $R^{205}$, $R^{208}$ et $R^{203}$ | représentent chacun, indépendamment les uns des autres, l'hydrogène, un groupe alkyle en $C_1$-$C_{20}$, cycloalkyle en $C_3$-$C_{10}$, alcényle en $C_2$-$C_{20}$, aryle en $C_6$-$C_{10}$, (alkyle en $C_1$-$C_{20}$)-C=O-, (cycloalkyle en $C_3$-$C_{10}$)-C=O-, (alcényle en $C_2$-$C_{20}$)-C=O-, (aryle en $C_6$-$C_{20}$)-C=O-, (alkyle en $C_1$-$C_{20}$)-$SO_2$-, (cycloalkyle en $C_3$-$C_{10}$)-$SO_2$-, (alcényle en $C_2$-$C_{20}$)-$SO_2$- ou (aryle en $C_6$-$C_{10}$)-$SO_2$- ou bien |
| $X^{104'}-R^{203}$ | représente l'hydrogène, un halogène, un groupe cyano, nitro, $CF_3$ ou $CCl_3$, |
| $R^{206}$ et $R^{207}$ | représentent chacun, indépendamment l'un de l'autre, l'hydrogène, un halogène, un groupe alkyle en $C_1$-$C_{20}$, alcoxy en $C_1$-$C_{20}$, cycloalkyle en $C_3$-$C_{10}$, alcényle en $C_2$-$C_{20}$ ou aryle en $C_6$-$C_{10}$, |

Y200 représente une liaison simple, -COO-, OCO-, -CONH-, -NHCO-, -CON($CH_3$)-, -N($CH_3$)CO-, -O-, -NH- ou -N($CH_3$)-,

$R^{201}$, $R^{202}$, $R^{206}$ représentent chacun, indépendamment les uns des autres l'hydrogène, un halogène, un groupe cyano, nitro, alkyle en $C_1$-$C_{20}$, alcoxy en $C_1$-$C_{20}$, phénoxy, cycloalkyle en $C_3$-$C_{10}$, alcényle en $C_2$-$C_{20}$ ou aryle en $C_6$-$C_{10}$, (alkyle en $C_1$-$C_{20}$)-C=O-, (aryle en $C_6$-$C_{10}$)-C=O-, (alkyle en $C_1$-$C_{20}$)-$SO_2$-, (alkyle en $C_1$-$C_{20}$)-(C=O)-O-, (alkyle en $C_1$-$C_{20}$)-(C=O)-NH-, (aryle en $C_6$-$C_{10}$)-(C=O)-NH-, (alkyle en $C_1$-$C_{20}$)-O-(C=O)-, (alkyle en $C_1$-$C_{20}$)-NH-(C=O)- ou (aryle en $C_6$-$C_{10}$)-NH-(C=O)-,

q, r et s sont égaux chacun, indépendamment les uns des autres à un nombre entier allant de 0 à 4, de préférence de 0 à 2,

$Q^{102}$ représente -O-, -S-, -(N-$R^{205}$)-, -C($R^{206}R^{207}$)-, -(C=O)-, -(CO-O)-, -(CO-N$R^{205}$)-, -($SO_2$)-, -($SO_2$-O), -($SO_2$-N$R^{205}$)-, -(C=N$R^{208}$)-, -(CN$R^{208}$-N$R^{205}$)-, -($CH_2$)$_p$-, p- ou m-$C_6H_4$- ou un groupe divalent de formule

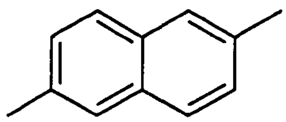

ou

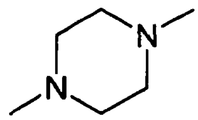

j est un nombre entier allant de 0 à 4, et lorsque j > 1 les divers symboles $Q^{102}$ peuvent avoir des significations différentes,

$T^{102}$ représente -($CH_2$)$_p$-, la chaîne pouvant être interrompue par -O-, -N$R^{209}$- ou -OSi$R^{220}{}_2$O-,

$S^{102}$ représente une liaison directe, -O-, -S- ou -N$R^{209}$-,

p est un nombre entier allant de 2 à 12, de préférence de 2 à 8 et plus spécialement de 2 à 4,

$R^{209}$ représente l'hydrogène, un groupe méthyle, éthyle ou propyle et

$R^{220}$ représente un groupe méthyle ou éthyle.

**13.** Polymère mélangé selon une ou plusieurs des revendications 1 à 12, **caractérisé en ce que** les monomères qui contiennent un groupement formanisotrope M répondent à la formule (CVII)

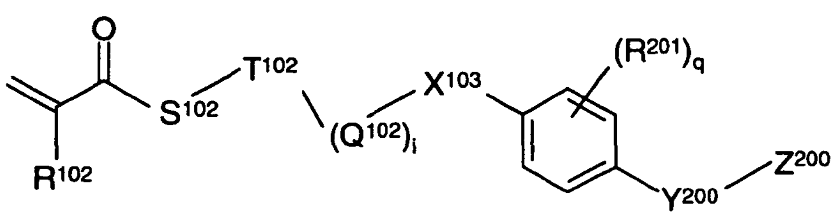

(CVII)

dans laquelle

$R^{102}$ représente l'hydrogène ou un groupe méthyle et

les autres symboles ont les significations indiquées ci-dessus.

**14.** Polymère mélangé selon la revendication 13, les monomères portant les groupes formanisotropes M étant choisis parmi ceux qui possèdent les structures suivantes :

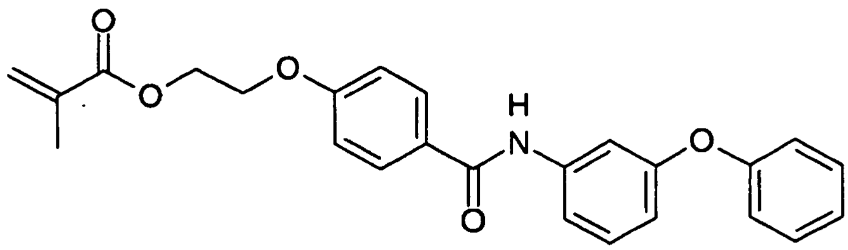

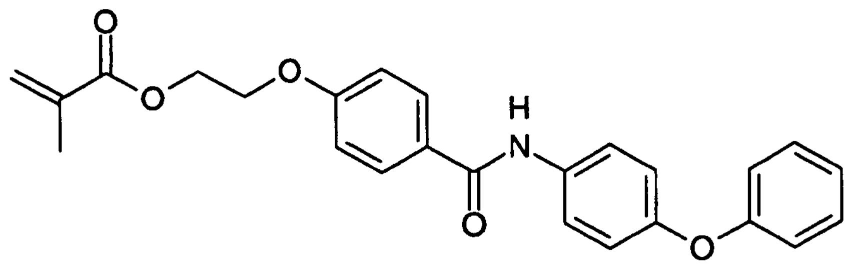

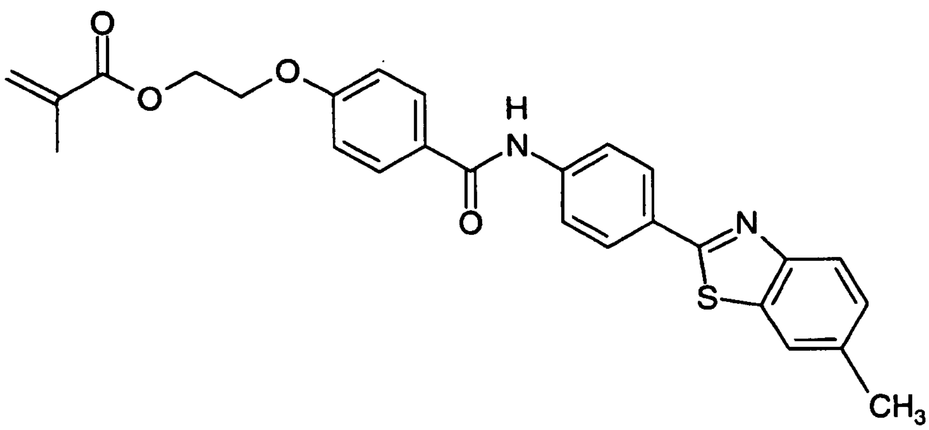

**15.** Polymère mélangé selon une ou plusieurs des revendications 1 à 14, **caractérisé en ce que** l'on met en oeuvre les monomères de formule (CV) et les monomères de formule (CVII) dans des proportions relatives de 1:1 à 1:30.

**16.** Polymère mélangé selon une ou plusieurs des revendications 1 à 15, **caractérisé en ce qu'**il a une densité optique ≤ 2.

**17.** Procédé pour la préparation des polymères mélangés selon une ou plusieurs des revendications 1 à 16 selon lequel on prépare les polymères (A) et (B) par polymérisation radicalaire puis on prépare les polymères mélangés par mélange de ces polymères individuels aux proportions relatives voulues en chauffant au-dessus de la température de transition du second ordre.

**18.** Utilisation des polymères mélangés selon une ou plusieurs des revendications 1 à 16 pour la fabrication d'éléments optiques et d'éléments enregistreurs, de préférence des enregistreurs en volume.

**19.** Utilisation des polymères mélangés selon la revendication 18, **caractérisée en ce que** l'élément optique est utilisé pour l'enregistrement de données.

**20.** Utilisation des polymères mélangés selon une ou plusieurs des revendications 18 à 19, **caractérisée en ce que**

l'élément optique ou l'élément enregistreur, de préférence un enregistreur en volume, est utilisé pour l'enregistrement de données par holographie.

**21.** Utilisation des polymères mélangés selon une ou plusieurs des revendications 18 à 20, **caractérisée en ce que** l'on enregistre la donnée dans l'élément optique et/ou l'enregistreur à l'aide d'un rayon laser.

**22.** Enregistreur, de préférence enregistreur en volume, contenant au moins un polymère mélangé selon une ou plusieurs des revendications 1 à 16, ce polymère mélangé ayant une épaisseur irradiée $\geq$ 0,1 mm.

**23.** Procédé pour la fabrication d'éléments optiques et d'éléments enregistreurs, de préférence des enregistreurs en volume, par moulage par injection selon une ou plusieurs des revendications qui précèdent.

**24.** Procédé selon la revendication 23, selon lequel l'objet moulé est en outre poli.

**25.** Procédé selon la revendication 23 et/ou 24, selon lequel on applique en outre une couche de protection transparente.

**26.** Eléments optiques et enregistreurs selon une ou plusieurs des revendications 23 à 25.